# EUROPEAN PATENT APPLICATION

(11) **EP 3 863 071 A1**
(43) Date of publication of application: **11.08.2021**
(21) Application number: 19868577.8
(22) Date of filing: 03.10.2019
(51) Int. Cl.: H01L 33/62, H01L 23/12, H01L 23/14, H01L 23/36, H01L 33/64, H05K 1/02

(54) **INLAY SUBSTRATE AND LIGHT EMISSION DEVICE IN WHICH SAME IS USED**

(30) Priority: 03.10.2018 JP 2018188030; 18.10.2018 JP 2018196303; 26.11.2018 JP 2018219910
(71) Applicant: Citizen Electronics Co., Ltd., Fujiyoshida-shi, Yamanashi 403-0001 (JP); Citizen Watch Co., Ltd., Nishitokyo-shi, Tokyo 188-8511 (JP)
(72) Inventor: AKIYAMA, Takashi, Fujiyoshida-shi, Yamanashi 403-0001 (JP); MIURA, Yuichi, Fujiyoshida-shi, Yamanashi 403-0001 (JP)
(74) Representative: Ricker, Mathias
(86) International application number: PCT/JP2019/039173
(87) International publication number: WO 2020/071498

(57) **Abstract**

A light emitting device having a plurality of light emitting elements, a first substrate having a plurality of wire layers and mounting the plurality of light emitting elements, a second substrate forming an opening into which the first substrate is inserted, and having smaller thermal conductivity than that of the first substrate, first wires disposed on the uppermost wire layer in the plurality of wire layers on the first substrate, and connected with the plurality of light emitting elements, second wires disposed on a wire layer different from the wire layer on which the first wires are disposed, and connected with the first wires via any of a plurality of through holes formed between the wire layers on which the first and second wires are disposed, third wires disposed on the second substrate, and fourth wires disposed across the boundary between the first substrate and the second substrate, and connecting the first wires with the third wires.

## Description

### FIELD

The present disclosure relates to an inlay substrate and a light emitting device using an inlay substrate.

### BACKGROUND

Light emitting devices are known in which light emitting elements such as light emitting diodes (LEDs) are mounted on a mounting substrate such as a printed circuit board.

In a high brightness lighting device using light emitting elements such as LEDs as light sources, the dissipation of heat generated by light emitting elements is a continuous problem. For example, an LED emitting device (adapter component 9) is described in Fig. 7 of JP 2017-63177 in which LEDs (4) are mounted on a metal substrate (heat spreader 3) formed by a material having a high thermal conductivity such as copper, a printed circuit board (PCB board 90) is adhered on the metal substrate, and the LEDs (4) emit by supplying power to the LEDs (4) via the printed circuit board from the outside of the LED emitting device. The LED light emitting device described in JP 2017-63177 has sufficient heat dissipation characteristics by contacting the metal substrate with an external heat sink. Bracketed terms and symbols in the above explanations indicate the terms and symbols used in JP-A-2017-63177.

However, since the materials having a high thermal conductivity such as copper are expensive, it is desired to reduce the amount of the materials used in emitting devices.
On the other hand, the LED light emitting devices are known that miniaturizes the portion relating to heat dissipation characteristics while maintaining a certain substrate size. For example, an LED light emitting device (LED module) is described in Fig. 7D of JP 2017-63177 in which a heat dissipation substrate (heat radiator 10) having higher thermal conductivity than a circuit substrate and having insulating properties is fitted into an opening (through hole) formed in a resin substrate (laminated PCB224), and LEDs are mounted on the heat dissipation substrate (LED module). In the LED light emitting device described in JP 2017-63177, a large part of heat generated by the LEDs conducts to a large heat sink (not shown) via LED heat sinks (83), the heat conductive electrode (73) formed on the heat dissipation substrate (10), the heat dissipation substrate (10), and a heat dissipation pattern formed on the heat dissipation substrate (10). Further, an LED light emitting device is described in Fig. 8B of JP 2017-63177 in which three LEDs are mounted on a heat dissipation board (10). Bracketed terms and symbols in the above explanation indicate the terms and symbols in JP 2017-63177.

A substrate fitted with a heat dissipation substrate to the resin substrate is referred to as inlay (fitting) substrate (hereinafter, such substrates are referred to as inlay substrates). As explained above, an inlay substrate conducts heat generated by the LEDs to a large heat sink thermally connected with the heat dissipation substrate via the heat dissipating substrate. Although an inlay substrate has a small heat dissipation substrate formed by an expensive material, an inlay substrate may efficiently release heat generated by LEDs, and a resin substrate may be used as a circuit board for mounting various circuits with less heat generation such as an LED drive circuit.

### SUMMARY

An inlay substrate (printed circuit board) is described in JP 2017-631 in which an LED is mounted on a heat dissipation substrate (heat radiator), and three LEDs are mounted on a heat dissipation substrate (heat radiator). However, a light emitting device mounting more light emitting elements is desired. For example, it is desired that a light emitting device for headlights of a vehicle may control the brightness so as not to distract pedestrians and drivers of other vehicles, by arranging a large number of light emitting elements in a matrix and controlling the lighting of each light emitting elements individually.

If a large number of light emitting elements are disposed in a matrix on the heat dissipation substrate included in the inlay substrate, such a headlight may be formed, however since a headlight emits light so as to project the light source at a distance using a lens, when the gap between the light emitting elements mounted on the heat dissipation substrate is large, the gap appears in projected images. Thus, if a large number of light emitting elements in such a light emitting device for headlights are disposed close to each other and mounted in high density, the light emitting device may prevent the gap of the light emitting element from appearing in the projected image.

However, when a large number of light emitting elements are mounted on the heat dissipation substrate in high density, it is not easy to dispose wires for supplying power to each light emitting elements individually. When light emitting elements on a heat dissipation substrate may be individually connected with terminals of a driver circuit on a resin substrate, end portions of wires connected with each light emitting elements are disposed on the peripheral portion of the heat dissipation substrate. However, when the light emitting elements are mounted in high density, the distances between the light emitting elements are narrowed i.e., about 100µm, and a line-and-space of wires connecting the end portions with the light emitting elements disposed in a matrix array is narrower than about 100µm. It is not easy to dispose wires on spaces among the light emitting elements disposed on the peripheral portion of the matrix arrangement.

An object of the present invention is to provide an inlay substrate having a high thermal conductivity substrate mounting a light emitting element in high density, and a light emitting device using such an inlay substrate.

Alight emitting device having a plurality of light emitting elements, a first substrate having a plurality of wire layers and mounting the plurality of light emitting elements, a second substrate forming an opening into which the first substrate is inserted, and having smaller thermal conductivity than that of the first substrate, first wires disposed on the uppermost wire layer in the plurality of wire layers on the first substrate, and connected with the plurality of light emitting elements, second wires disposed on a wire layer different from the wire layer on which the first wires are disposed, and connected with the first wires via any of a plurality of through holes formed between the wire layers on which the first and second wires are disposed, third wires disposed on the second substrate, and fourth wires disposed across the boundary between the first substrate and the second substrate, and connecting the first wires with the third wires.

Further, it is preferable in the light emitting device that the wire layer on which the first wires are disposed is the front surface of the first substrate, the wire layer on which the second wires are disposed is the rear surface of the first substrate, and the plurality of through holes are formed so as to penetrate the inside of the first substrate in the thickness direction.

Further, it is preferable that the light emitting device has a heat conductive layer disposed so as to face to the rear surfaces of the first and second substrates, and an insulating heat conductive layer disposed between the first and second substrates and the heat conductive layer, conducts heat conducted from the plurality of light emitting elements via the first substrate to the heat conductive layer, and insulating the heat conductive layer with the second wires disposed on the rear surface of the first and second substrates.

Further, it is preferable in the light emitting device that the first substrate includes a silicon substrate, wherein an insulating layer is formed on the surface of the silicon substrate, the wire layer on which the first wires are disposed is the surface of the insulating layer, the wire layer on which the second wires are disposed is the surface of the silicon substrate covered by the insulating layer, and the plurality of through holes are formed so as to penetrate the inside of the insulating layer in the thickness direction.

Further, it is preferable in the light emitting device that wherein the thickness of the first wires disposed in an array region is thicker than that of the first wires disposed outside an array region.

Further, an inlay substrate in the light emitting device, the first substrate and the second substrate are integrated by fixing the first substrate so as to insert the first substrate into an opening of the second substrate. First wires, insulating layer and second wires are laminated on the silicon substrate. An electrode of the LED is connected with one third wire on the second substrate via one first wire, one through hole, one second wire, other through hole, other first wire and one four wire. Heat generated by each LEDs is conducted to heat sink via connections between the LEDs and the first substrate, the first substrate, a connection between the first substrate and an outside heat sink.

Further, it is preferable in the light emitting device that that the first substrate further includes a ceramic substrate mounting the silicon substrate.

Further, it is preferable in the light emitting device that the first substrate further includes a ceramic substrate mounting the silicon substrate.

Further, it is preferable in the light emitting device that the area of the ceramic substrate in planar view is larger than that of the silicon substrate.

Further, it is preferable in the light emitting device that the first substrate further includes a ceramic substrate mounting the silicon substrate.

An inlay substrate has a first substrate having a plurality of wire layers and capable of mounting a plurality of light emitting elements, a second substrate forming an opening into which the first substrate is inserted, and having smaller thermal conductivity than that of the first substrate, first wires disposed on the uppermost wire layer in the plurality of wire layers on the first substrate, second wires disposed on a wire layer different from the wire layer on which the wires are disposed, and connected with the first wires via a plurality of through holes formed between the wire layers on which the first and second wires are disposed, third wires disposed on the second substrate; and, fourth wires disposed across the boundary between the first substrate and the second substrate, and connecting the first wires with the third wires.

Further, in the inlay substrate that the wire layer on which the first wires are disposed is the front surface of the first substrate, the wire layer on which the second wires are disposed is the rear surface of the first substrate, and the plurality of through holes are formed so as to penetrate the inside of the first substrate in the thickness direction.

According to the light emitting device according to the embodiment, semiconductor elements are mounted in high density on portions having high the thermal conductivity of the substrate.

### BRIEF DESCRIPTION OF THE DRAWINGS

Fig.1 is a figure showing an onboard headlight having a light emitting device according to the first embodiment;
Fig. 2A is a perspective view of the light emitting element shown in Fig. 1, Fig. 2B is a cross-sectional view of the light emitting element along the line AA' of Fig. 2A, Fig. 2C is a bottom view of the light emitting element shown in Fig. 1;
Fig. 3A is a planar view of the light emitting device shown in Fig. 1, and Fig. 3B is a sectional view along the line BB' shown in Fig 3A;
Fig. 4 is an exploded perspective view of the second substrate shown in Figs.3A to 3C;
Fig. 5 is a partially enlarged view of the upper surface of the light emitting element indicated by an arrow C in Fig. 3A;
Fig. 6 is a figure showing wires included in the comparative example for comparing with the wire connection shown in Fig. 5;
Figs. 7A to 7E are cross-sectional (part 1) views indicating a manufacturing method of a light emitting device shown in Fig. 1, Fig. 7A shows a first step, Fig. 7B shows a second step next to the first step, and Fig. 7C shows a third step next to the second step, Fig. 7D shows a fourth step, Fig. 7E shows a fifth step next to the fourth step;
Figs. 8A to 8E are cross-sectional (part 2) views indicating a manufacturing method of a light emitting device shown in Fig. 1, Fig. 8A shows a sixth step, Fig. 8B shows a seventh step following the sixth step, Fig. 8C shows an eighth step following the seventh step, Fig. 8D shows a ninth step following the eighth step, and Fig. 8E shows a tenth step following the ninth step;
Figs. 9A to 9D are cross-sectional (part 3) views indicating a manufacturing method of a light emitting device shown in Fig. 1, Fig. 9A shows an11th step next to the 10th step, Fig. 9B shows a 12th step next to the 11th step, Fig. 9C shows a 13th step next to the 12th step, and Fig. 9D shows a 14th step next to the 13th step;
Fig. 10 is a planar view of the light emitting device of a second embodiment;
Fig. 11 is an exploded perspective view of the inlay substrate included in the light emitting device shown in Fig. 10;
Fig. 12 is a cross-sectional view of the light emitting device along the line AA' of Fig. 10;
Fig. 13 is a main cross-sectional view of the light emitting device shown in Fig. 10;
Fig. 14 is a main cross-sectional view of the light emitting device of a third embodiment;
Fig. 15 is a main cross-sectional view of the light emitting device of a fourth embodiment;
Fig. 16 is a main cross-sectional view of the light emitting device of a fifth embodiment;
Fig. 17 is a planar view of a light emitting device of a sixth embodiment showing the light emitting portion and its peripheral portion;
Fig. 18A is a planar view of a light emitting device of a seventh embodiment, Fig. 18B is a cross-sectional view thereof, and Fig. 18C is a bottom view thereof;
Fig. 19 is a circuit figure of a circuit on the first substrate shown in Fig. 17;
Fig. 20 is a planar view of a light emitting device shown in Fig. 17 showing the light emitting portion and its peripheral portion; and
Fig. 21 is a planar view of a light emitting device of a eighth embodiment showing the light emitting portion and its peripheral portion.

### DESCRIPTION OF EMBODIMENTS

Hereinafter, light emitting devices according to the present invention will be described with reference to the accompanying figures in detail. However, the technical scope of the present invention is not limited to those embodiments, but includes the claimed invention and its equivalents.

### (Outline of a light emitting device according to the embodiment)

In the light emitting device according to the embodiment, a printed circuit board having a resin as a base material (hereinafter referred to as second substrate) is fitted with a heat dissipation substrate having a high thermal conductivity ceramic a base material (hereinafter referred to as first substrate) and light emitting elements are mounted on the first substrate by forming through holes penetrating in the thickness direction of the first substrate, and therefore the light emitting elements may be mounted in high density on the first substrate having a high thermal conductivity.

### (First Embodiment)

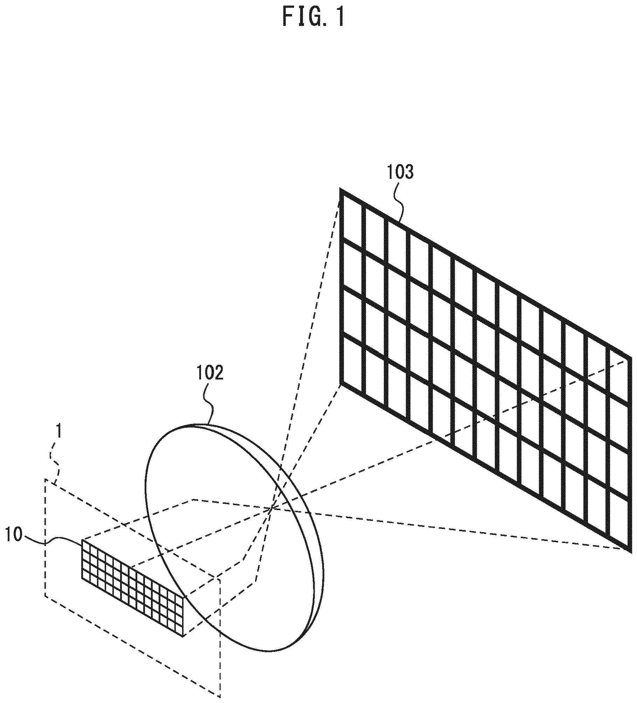

Fig.1 is a figure showing an onboard headlight having a light emitting device according to the first embodiment.

A headlight has a light emitting device 1 in which a plurality of light emitting elements 10 are mounted in an array, and a projection lens 102, light emitted from the light emitting device 1 is projected by the projection lens 102 on a projection surface 103 (virtually provided for purposes of explanation) apart from the projection lens 102. The light emitting device 1 may carry out a high beam variable headlight (hereinafter referred to as ADB (Adaptive Driving Beam)) operation for matrix-controlling the brightness of the plurality of light emitting elements 10 in response to control signals input from a control device. The headlight does not interfere with views of pedestrians and drivers driving oncoming and preceding vehicles by the ADB operation during a high beam illumination in order to illuminate a long distance, by turning off light emitting elements corresponding to the position where the pedestrians, the oncoming and preceding vehicles in the projection surface 103 are presented.

If the arrangement interval among the light emitting element 10 on the light emitting device 1 (hereinafter referred to as element distance) is wide, the dark portion generated by the element distance of the light emitting element 10 in the projection surface 103 is wider, and therefore light irradiation on the projection is worse. Thus, it is preferable for the light emitting device 1 to mount the light emitting element 10 at a high density in a narrow arrangement interval. The narrower the arrangement intervals of the light emitting elements 10 are, the narrower dark portions between the elements are, and therefore the light emitting device 1 may have good light irradiation characteristics on the projection.

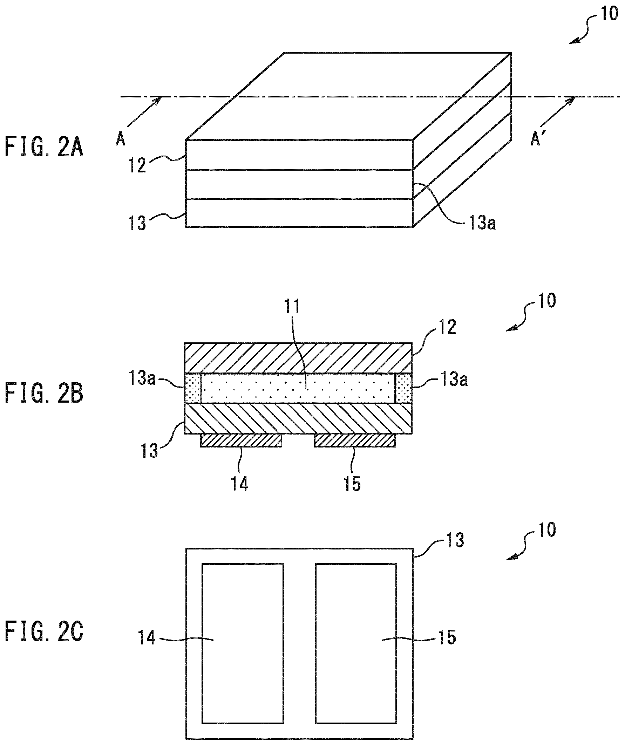

Fig. 2A is a perspective view of the light emitting element 10, Fig. 2B is a cross-sectional view of the light emitting element along the line AA' of Fig. 2A, Fig. 2C is a bottom view of the light emitting element 10. As shown in Fig. 2A, in the light emitting element 10, it is observed that a sealing resin 13a and a light conversion layer 12 are laminated on a submount substrate 13. As shown in Fig. 2B, on a cross-section of the light emitting element 10, an LED die 11 is mounted on the submount substrate 13, the light conversion layer 12 is laminated on the LED die 11, the sealing resin 13a is disposed so as to surround the periphery of the LED die 11, and an anode electrode 14 and a cathode electrode 15 are formed on a bottom surface of the submount substrate 13. As shown in Fig. 2C, the light emitting element 10 has a square shape in planar view, and the anode electrode 14 and the cathode electrode 15 has a rectangular shape in planar view.

The light emitting element 10 is referred to as a CSP (Chip Size Package), and has a structure that allows a package size as close as possible to the die size of the LED die 11 in planar view. The LED die 11 emits blue light with a wavelength band of about 450nm to 460nm, and has a reflective layer (not shown) at the bottom. The submount substrate 13 mounts the LED die 11, and has the anode electrode 14 and the cathode electrode 15. The sealing resin 13a has a light-transmitting layer disposed on the LED die 11 and a reflective layer around the light-transmitting layer, and guides lights emitted from the LED die 11 toward the upward direction. The light conversion layer 12 is laminated over the LED die 11 containing YAG (yttrium aluminum garnet) phosphors. The YAG phosphors convert the blue light emitted from the LED die 11 to yellow light, and emit the yellow light. The light emitting element 10 emits white light by mixing blue light emitted by the LED die 11 and yellow light emitted by the YAG phosphors. The phosphors contained in the light conversion layer 12 are not limited to phosphors that emit yellow light such as YAG phosphor, and may be phosphors that emit green light and red light.

When a predetermined DC voltage is supplied between the anode electrode 14 and the cathode electrode 15, forward currents flow via the LED dies 11, and therefore the light emitting elements 10 emit blue light.

The element size of the light emitting element 10 is 0.6mm×0.6mm, the element size of the LED die 11 is about 0.4mm×0.4mm. The length of the short side of the anode electrode 14 and cathode electrode 15 is 0.2mm, and the distance between the anode electrode 14 and the cathode electrode 15 is 0.1mm. Further, the distance between the anode electrode 14 and cathode electrode 15, and the outer edge of the submount substrate 13 is 0.05mm. The above explained element size of the light emitting element 10 is an example, and the side length of the light emitting element 10 may be longer than 0.6mm, or be shorter than 0.6mm.

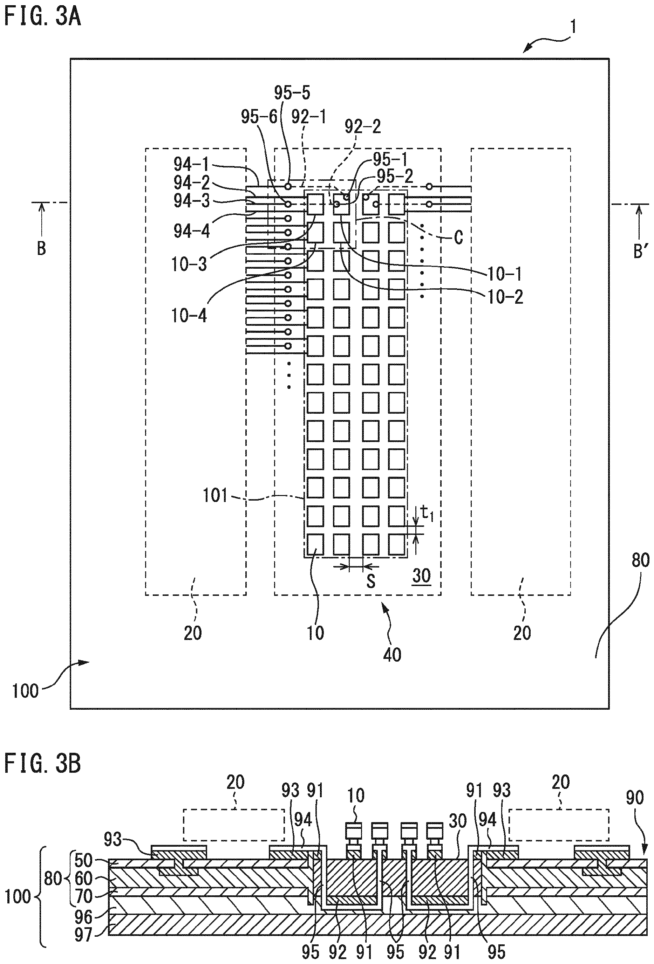

Fig. 3A is a planar view of the light emitting device 1, and Fig. 3B is a sectional view along the line BB' shown in Fig 3A. In Fig 3B, although heat dissipation members (such as a so-called large heat sink or fan) are additionally disposed on the light emitting device 1, the heat dissipation members are not described in Fig. 3B for clarifying explanations.

The light emitting device 1 has the plurality of light emitting elements 10, a control circuits 20, and a mounting substrate 100. The plurality of light emitting elements 10 are disposed on the first substrate 40 of the mounting substrate 100 in an array, i.e., disposed by a predetermined number in the longitudinal and lateral directions. In the light emitting device 1, 13 light emitting elements 10 are disposed at intervals t1 in the longitudinal direction, and 4 light emitting elements 10 are disposed at intervals s in the lateral direction. The arrangement of the light emitting elements 10 is not limited to that of Fig. 3A, and may be different from that of Fig. 3A.

A control circuits 20 are semiconductor circuits formed on a silicon substrate, and are electrically connected with each of the plurality of light emitting elements 10 via the first wires 91 to the fourth wires 94 and the through holes 95, and turn on and off the plurality of light emitting elements 10 individually based on instructions of a host control circuit such as a CPU. The control circuits 20 supply predetermined currents to the light emitting elements 10 to be turned on, and the turned-on light emitting elements 10 emit light, and supplies no currents to the light emitting elements 10 be turned off, and the turned-off light emitting elements 10 does not emit light. The wires connected the control circuits 20 with the upper control circuit are not shown. Although the control circuits 20 in the present embodiment controls the light emission by supplying currents, the control circuits 20 may be a PWM drive for controlling the ratio of the on-off time. Although the control circuits are not limited as long as the control circuits matrix control the light emitting elements 10, it is necessary to connect the individual wires of the light emitting elements 10 with the control circuits 20.

The mounting substrate 100 includes an inlay substrate 90 having a first substrate 40 and a second substrate 80, a heat conductive layer adhesive sheet 96 (an insulating heat conductive layer) and a heat conductive layer 97 attached to the inlay substrate 90. The first substrate 40 has a base material 30 which is rectangular flat plate material made of ceramics such as aluminum nitride (AlN) or alumina (Al₂O₃), and the first wires 91, the second wires 92 and the through holes 95 disposed on the base material 30, and is fitted into the opening in the second substrate 80. The first wires 91 are disposed on the surface of the first substrate 40, and include metal pattern portions for mounting the light emitting elements 10. The second wires 92 are disposed on the rear surface of the first substrate 40, and are electrically connected with the first wires 91 via through holes 95. In the first substrate 40, the surface of the first substrate 40 on which the first wires 91 are disposed is the uppermost wire layer, and the rear surface of the first substrate 40 on which the second wires 92 are disposed is a wire layer different from the wire layer on which the first wires 91 are disposed. The through holes 95 are formed so as to penetrate the inside of the first substrate 40 in the thickness direction, and conductive materials such as copper are filled therein. Third wires 93 are disposed on the surface of the second substrate 80. The fourth wires 94 are disposed across the surfaces of the first substrate 40 and the second substrate 80, electrically connect the first wires 91 with the third wires 93.

The first wires 91 to the fourth wires 94 and the through holes 95 are electrically connected between the light emitting elements 10 and the control circuits 20. One first wire 91 connected with the light emitting element 10 is electrically connected with one second wire 92 via one through hole 95 disposed on the array region 101 in which the plurality of light emitting elements 10 are mounted, and the one second wire 92 is electrically connected with other first wire 91 via another through hole 95 disposed outside the array region 101.

A thermal conductive layer adhesive sheet 96 is a semi-cured insulating sheet material having resin-based adhesive containing high thermal conductivity insulating members such as boron nitride, aluminum nitride, alumina, silicon nitride and magnesium oxide as fillers. The heat conductive layer adhesive sheet 96 is cured by thermal pressing with adhering the first substrate 40 and the second substrate 80 to the heat conductive layer 97. Furthermore, the heat conductive layer adhesive sheet 96 conducts heat conducted from the light emitting elements 10 via the first substrate 40 to the heat conductive layer 97, and insulating the second wires 92 and the heat conductive layer 97 disposed on the rear surface of the first substrate 40.

The heat conductive layer 97 is a rectangular flat plate material made of the same material as the first substrate 40, and is disposed so as to cover all of the rear surface of the first substrate 40 and second substrate 80 via the heat conductive layer adhesive sheet 96. The mounting substrate 100 is reinforced by the thermally conductive layer 97 and is easier to handle. The lower surface of the heat conductive layer 97 is connected with a heat sink (not shown) with a low thermal resistance.

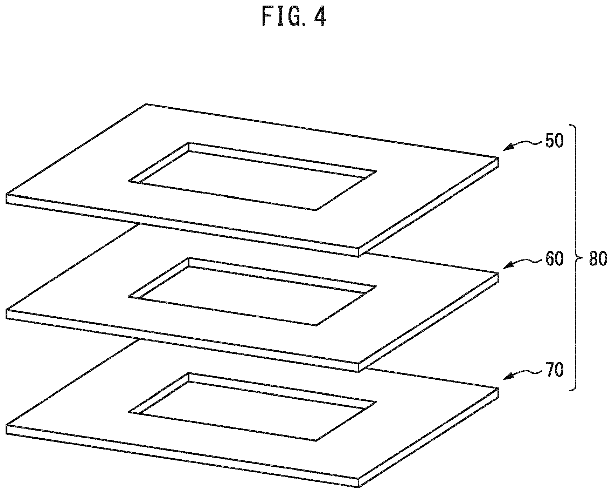

Fig. 4 is an exploded perspective view of the second substrate 80.

The second substrate 80 has a first resin substrate 50, a substrate adhesive sheet 60 and a second resin substrate 70. The first resin substrate 50 is a substrate in which conductive layers made of a metal material such as copper are disposed on both surfaces of a plate material formed by curing a glass cloth with such as epoxy resin. For example, the thicknesses of the coppers disposed on both sides of the first resin substrate 50 may be from about 10µm to about 30µm, so that the coppers are not removed by polishing in manufacturing process of the mounting substrate 100.

The substrate adhesive sheet 60 is a sheet which is semi-cured by impregnating a glass fiber with an adhesive, is referred to as a prepreg, and adhering the first resin substrate 50 and the second resin substrate 70, by cured by thermal pressing with sandwiched by the first resin substrate 50 and the second resin substrate 70.

The second resin substrate 70 is a plate material formed by curing a glass cloth with such an epoxy resin, similar to the first resin substrate 50. The second resin substrate 70 is different from the first resin substrate 50 in that the copper foil is not formed.

The respective thermal conductivities of the first resin substrate 50 and the second resin substrate 70 made of a synthetic resin, and the substrate adhesive sheet 60 are smaller than that of the first substrate 40 made of ceramic. The thermal conductivity of the first substrate 40 is larger than that of the second substrate 80. For example, the conductivity of the ceramic contained in the first substrate 40 is 160W/mK, and the conductivity of the epoxy resin contained in the second substrate 80 is 0.5W/mK. Since other members included in each of the first substrate 40 and the second substrate 80 is thin, the thermal conductivity of the first substrate 40 is close to that of ceramic, and the thermal conductivity of the second substrate 80 is close to that of epoxy resin.

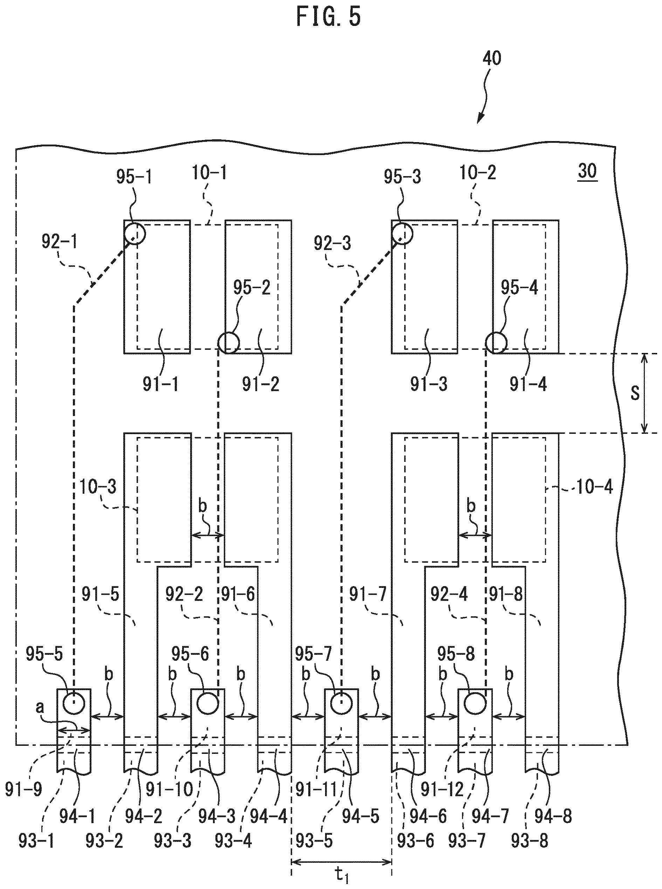

Fig. 5 is a partially enlarged view of the upper surface of the light emitting element 1 indicated by an arrow C in Fig. 3A.

The anode electrode of a light emitting element 10-1 is connected with a first wire 91-1, and the cathode electrode of the light emitting element 10-1 is connected with a first wire 91-2. The first wire 91-1 connected with the anode electrode of the light emitting element 10-1 is connected with the control circuits 20 via a through hole 95-1, a second wire 92-1 disposed on the rear surface of the first substrate, a through hole 95-5, a first wire 91-9, a fourth wire 94-1 disposed across the surfaces of the first substrate 40 and second substrate 80, and a third wire 93-1. The first wire 91-2 connected with the cathode electrode of the light emitting element 10-1 is connected with the control circuits 20 via a through-hole 95-2, a second wire 92-2 disposed on the rear surface of the first substrate, a through-hole 95-6, a first wire 91-10, the fourth wire 94-3 disposed across surfaces of the first substrate 40 and second substrate 80, and the third wire 93-3.

The anode electrode of a light emitting element 10-2 is connected with the first wire 91-3, and the cathode electrode of a light emitting element 10-2 is connected with the first wire 91-4. A first wire 91-3 connected with the anode electrode of the light emitting element 10-2 is connected with the control circuits 20 via a through hole 95-3, a second wire 92-3 disposed on the rear surface of the first substrate 40, a through hole 95-7, a first wire 91-11, a fourth wire 94-5 disposed across the surfaces of the first substrate 40 and the second substrate 80, and a third wire 93-5. A first wire 91-4 connected with the cathode electrode of the light emitting element 10-2 is connected with the control circuits 20 via a through-hole 95-4, a second wire 92-4 disposed on the rear surface of the first substrate 40, a through-hole 95-8, a first wire 91-12 a fourth wire 94-7 disposed across the surface of the first substrate 40 and the surface of the second substrate 80, and the third wire 93-7.

The anode electrode of the light emitting element 10-3 is connected with the control circuits 20 via a first wire 91-5, a fourth wire 94-2 disposed across the surfaces of the first substrate 40 and second substrate 80, and a third wire 93-2, and the cathode electrode of the light emitting element 10-3 is connected with the control circuits 20 via a first wire 91-6, a fourth wire 94-4 disposed across the surfaces of the first substrate 40 and the second substrate 80, and a third wire 93-4. The anode electrode of the light emitting element 10-4 is connected with the control circuits 20 via a first wire 91-7, a fourth wire 94-6 disposed across the surfaces of the first substrate 40 and the second substrate 80 and a third wire 93-6, and the cathode electrode of the light emitting element 10-4 is connected with the control circuits 20 via a first wire 91-8, a fourth wire 94-8 disposed across the surfaces of the first substrate 40 and second substrate 80, and a third wire 93-8.

The portions of the first wires 91-1 and 91-2 electrically connected by solder with the anode electrode and cathode electrode of the light emitting element 10-1 are referred to as lands, mounting pads or electrode pads. The portions of other wires except for the first wires 91-1 and 91-2 are referred to as lands, mounting pads or electrode pads. Further, in Fig. 5, the width of the first wire 91 except for the land is the line width a, and the interval between the first wires 91 is the line spacing b.

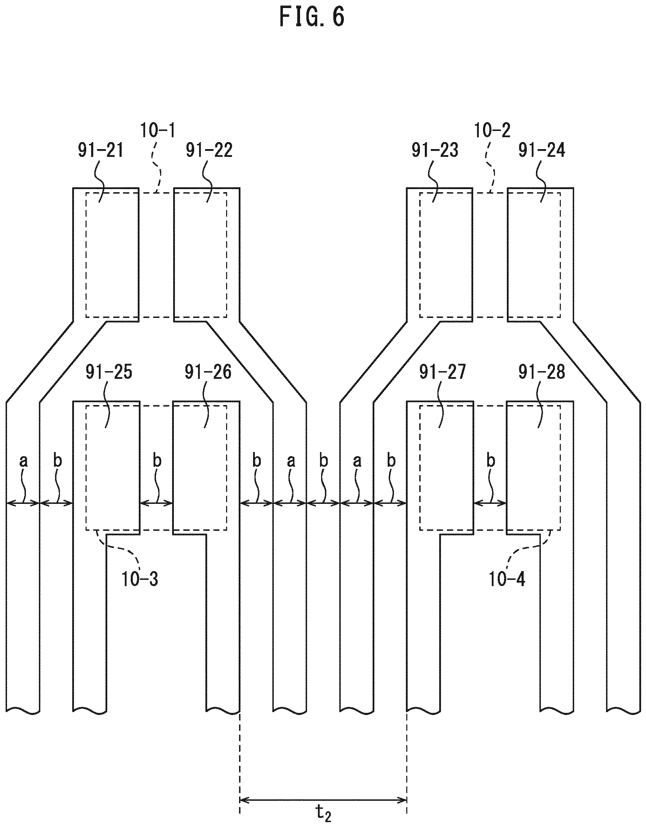

Fig. 6 is a figure showing wires included in the comparative example for comparing with the wire connection shown in Fig. 5.

Hereinafter, it will be explained with reference to Figs. 5 and 6. The arrangement pitch of the light emitting element 10 included in the light emitting device 1 may be reduced, as compared with that of the comparative example. In the first substrate 40 included in the light emitting device 1, since the through holes 95-1 to 95-8 are disposed, the arrangement pitch of the light emitting elements 10 is reduced by a distance (a+b) corresponding to one pitch of the wire compared to the comparative example on which the through holes 95-1 to 95-8 are not disposed.

As shown in Fig. 5, in the light emitting device 1, the first wires 91 on the front surface of the first substrate 40 and the second wires 92 on the rear surfaces of the first substrate 40 are connected via the through holes 95. In contrast, wires in the comparative example shown in Fig. 6 are only disposed on the surface of the first substrate 40 with forming no through holes. The light emitting elements 10 in the comparative example shown in Fig. 6 are connected with the control circuits 20 (not shown) via the first wires 91-21 to 91-28, and the width of the first wire 91 is the line width a, and the distance between the first wires 91 is a line spacing b. In the first substrates of the light emitting device 1 and comparative example, the minimum wire is width a, and the minimum wire interval is b.

The differences in arrangements of the light emitting elements 10 between the light emitting device 1 and the comparative example will be explained. In the light emitting device 1 shown in Fig. 5, when the light emitting elements 10 are disposed in two stages from the lower side to the upper side of the figure, the distance t1 between the light emitting elements 10 (distance between the elements) may be (a+2b). On the other hand, in the comparative example shown in Fig. 6, when the light emitting elements 10 are disposed in two stages from the lower side to the upper side of the figure, since all of the wires are disposed on the one plane, the distance t2 between the light emitting elements 10 may be (2a+3b). In the light emitting device 1, when the light emitting elements are disposed in two stages from the lower side to the upper side of the figure, since the through holes are formed, the interval (or pitch) between the light emitting elements 10 may be reduced by (a+b) as compared with the comparative example.

It is known that light emitted from the LED die 11 is proportional to the current flowing via the LED die 11 in a predetermined current range. Since the light emission intensity of the light emitting device 1 is large, a current of about 100mA flows through each of light emitting elements 10. Thus, the thickness of the first wire 91 is preferably 17µm or more, and the line width a is preferably 100µm or more. When the first wire 91 is thick, it is preferable that the wire interval b is 100µm or more in order to prevent the wires from being short at a wire forming manufacturing process by photolithography. In the light emitting device 1, the thickness of all the first wires 91 is 35µm, the line width a of the first wires 91 is 100µm, and the line interval b between the first wires 91 is 100µm.

Thus, the arrangement interval t1 of the light emitting elements 10 in the light emitting device 1 may be 300µm. Since the arrangement interval t2 of the light emitting elements 10 in the comparative example in which the through holes 95 are not formed is 500µm, the interval of the light emitting elements 10 in the light emitting device 1 may reduce by 200µm as compared with the comparative example. As explained above, since when the arrangement interval of the light emitting elements 10 in the light emitting device 1 is narrower, irradiation characteristics of light on a projection surface may be good, the advantage by reducing the arrangement interval of the light emitting elements 10 is large.

In the light emitting device 1, the interval s among the light emitting elements 10 in the vertical direction in the figure is 250µm. The interval is the lower limit of the arrangement interval of a mounting device (not shown) which mounts the light emitting elements 10. However, the interval s among the elements may be other values based on the available mounting device.

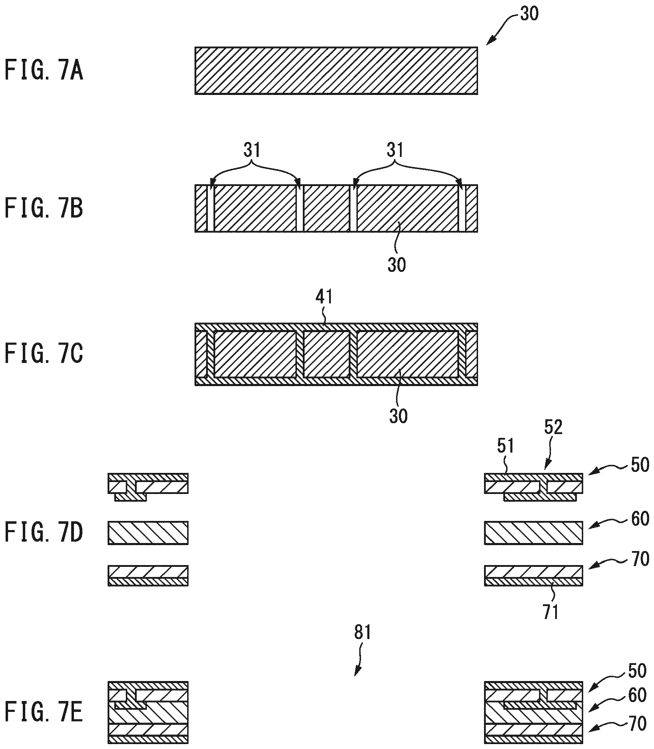

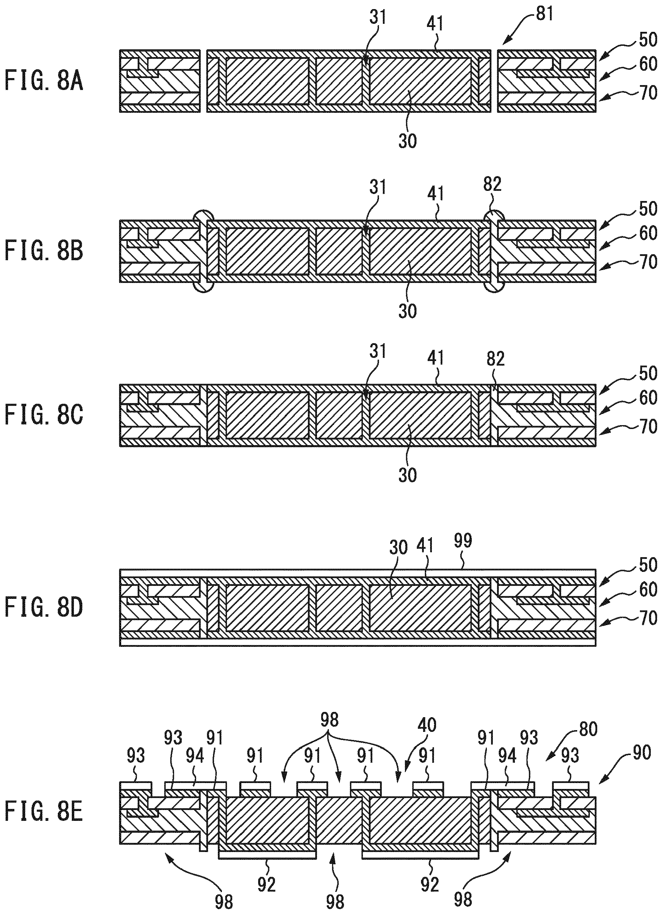

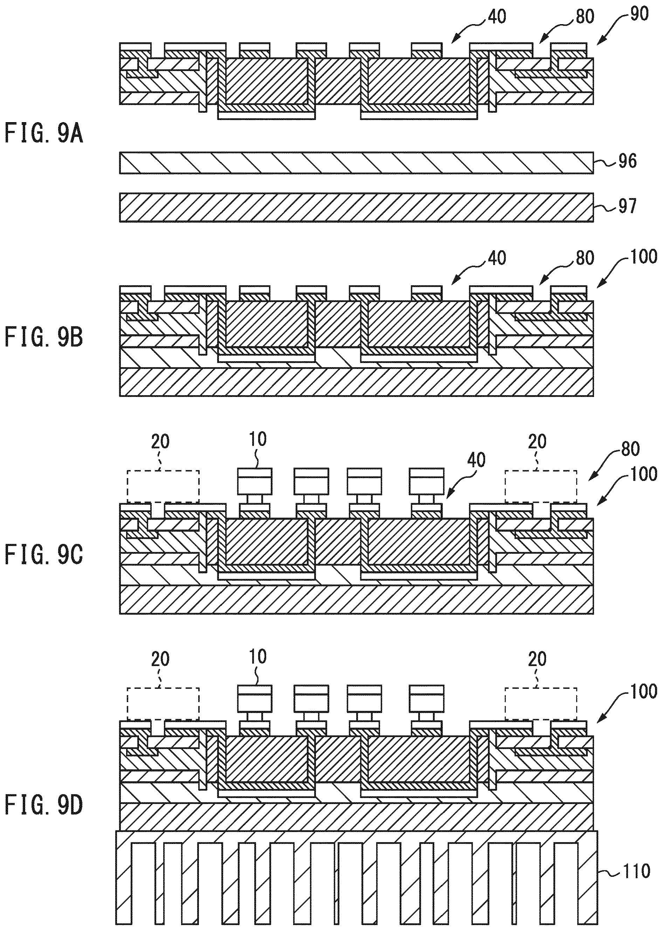

Figs. 7A to 9D are cross-sectional views of a light emitting device 1 indicating a manufacturing method of a light emitting device 1. Figs. 7A to 7C shows a step preparing the first substrate 40 (the base material 31) before fitting to the second substrate 80. Fig. 7A shows a first step, Fig. 7B shows a second step next to the first step, and Fig. 7C shows a third step next to the second step. Figs. 7D and 7E show a step preparing the second substrate 80 before fitting the first substrate 40. Fig. 7D shows a fourth step, Fig. 7E shows a fifth step next to the fourth step. Figs. 8A to 8E and 9A to 9D show steps according to the mounting substrate 100 in which the first substrate 40 is fitted to the second substrate 80. Fig. 8A shows a sixth step, Fig. 8B shows a seventh step following the sixth step, Fig. 8C shows an eighth step following the seventh step, Fig. 8D shows a ninth step following the eighth step, and Fig. 8E shows a tenth step following the ninth step. Fig. 9A shows an11th step next to the 10th step, Fig. 9B shows a 12th step next to the 11th step, Fig. 9C shows a 13th step next to the 12th step, and Fig. 9D shows a 14th step next to the 13th step.

First, in the first step shown in Fig. 7A, the substrate 30 made of a ceramic material having high thermal conductivity is prepared. Then, in the second step as shown in Fig. 7B, a plurality of through holes 31 are formed to the substrate 30 by through-hole processing using laser. Then, in the third step shown in Fig. 7C, copper wire layers 41 are formed on the front and rear surfaces of the substrate 30. The copper wire layers 41 are formed by forming thick copper film having 50um thickness by an electrolytic plating method, after forming copper seed layers by sputtering or vapor deposition so that the thickness of copper seed layers are 0.1µm to 0.5µm. On the step, the through holes 31 have conductive property by filled with copper.

Apart from the step of manufacturing the first substrate 40 (substrate 30), in the fourth step shown in Fig. 7D, through holes (the opening 81 in the second substrate) for inserting the first resin substrate 50 are formed on the substrate 30, the substrate adhesive sheet 60 and the second resin substrate 70 before drilling. Since the size of the through holes is 50um larger than that of the substrate 30, the substrate 30 may be easily inserted into the through hole. The through holes are formed by a die press or router processing, and may be formed at once by overlapping the respective sheets, and may be formed individually each sheet. In the embodiment, three overlapped sheets are die pressed so as to form through hole having similar size. Thus, the first resin substrate 50, the substrate adhesive sheet 60 and the second resin substrate 70 are a frame members having similar shape in planar view. Copper wire layers 51 are disposed on the front and rear surfaces of the first resin substrate 50, and the through holes 95 for electrically connecting between the copper wire layers 51 on the front and rear surfaces are formed so as to penetrate the inside of the first resin substrate 50, and at least the rear surface of first resin substrate 50 is patterned. The pattering step is included in the general printed circuit board manufacturing method having the double-sided wires, and therefore the pattering step is carried out prior to the fourth step.

Then, in the fifth step shown in Fig. 7E, the first resin substrate 50, the substrate adhesive sheet 60 and the second resin substrate 70 are disposed superimposed. In the fifth step, since the substrate adhesive sheet 60 is not thermally pressed, the substrate adhesive sheet 60 is in a semi-cured state before curing. An opening 81 penetrating the inside of the substrate adhesive sheet 60 and the second resin substrate 70 in the thickness direction is formed at the center of the first resin substrate 50, the substrate adhesive sheet 60 and the second resin substrate 70. The opening 81 is a through hole in which substrate 30 (the first substrate when completed) is fitted.

In the sixth step shown in Fig. 8A, the base material 30 (hereinafter, referred to as the first substrate even before completion) is fitted into the opening 81 formed on the second substrate 80 before the thermal press. When the first substrate 40 is fitted into the opening 81, since the size of the opening 81 is 50µm larger than that of the first substrate 40, the inner walls of the first resin substrate 50, the substrate adhesive sheet 60 and the second resin substrate 70 are apart from the outer wall of the base material 30.

Then, in the seventh step shown in Fig. 8B, the first resin substrate 50, the substrate adhesive sheet 60 and the second resin substrate 70 are thermally pressed from the front and rear surfaces. When the first resin substrate 50, the substrate adhesive sheet 60 and the second resin substrate 70 are thermally pressed, the substrate adhesive sheet 60 is cured, and adhesive band 82 is formed by filling adhesive contained in the substrate adhesive sheet 60 between the outer wall of the first substrate 40 and the inner walls of the first resin substrate 50, the substrate adhesive sheet 60 and the second resin substrate 70 (hereinafter, also referred to as second substrate before completion). The adhesive band 82 is ejected from the front and rear surfaces of the opening 81, and protrusions are formed.

Then, in the eighth step shown in Fig. 8C, the protrusions of the adhesive band 82 are removed which are formed on the front and rear surfaces of the first substrate 40 and the second substrate 80 in the seventh step. For example, the protrusions formed on the front and rear surfaces of the first substrate 40 and the second substrate 80 are polished by polishing processing so that the front and rear surfaces of the adhesive band 82 are the same surface as the front and rear surfaces of the copper wire layer 41.

Then, in the ninth step shown in Fig. 8D, copper plating layers 99 are disposed by an electroless plating method. The copper plating layers 99 are disposed on the upper layer of the copper wire layer 41 by the ninth step. Further, the copper plating layers 99 are disposed on the front surface of the first resin substrate 50 and the rear surface of the second resin substrate 70. Furthermore, the copper plating layers 99 are formed on the adhesive band 82 planarized by the polishing process of the eighth step. Thus, the copper wire layer 41 disposed on the surface of the second substrate 80 is electrically connected with the copper wire layer 51 formed on the surface of first substrate 40. For example, the thickness of the copper plating layers 99 is 50µm. The thickness of the copper plating layers 99 is determined in accordance with the current supplied to the light emitting elements 10 and the wire pitch of the first wires 91.

Then, in the tenth step shown in Fig. 8A, wire patterns are formed. Processes similar to the patterning process of common copper wire may be used. First, resists are applied on both surfaces of the substrate, and the resists are exposure-cured by using a mask figuring the wire patterns shown in Fig. 5 to remove unnecessary resists. Thereafter, the copper wire layers 41 and 51 (refer to Fig. 7D) and the copper plating layers 99 other than the wire portion protected by the resists are removed by copper etching, and therefore the wire patterns of the first wires 91 to fourth wires 94 are formed. In the tenth step, the removal portions 98 are removed from the copper layers of the copper plating layers 99, the copper wire layers 41 and 51 disposed in the ninth step, and therefore the first wires 91 to the fourth wires 94 are formed. The composite substrate 90 including the first substrate 40 and the second substrate 80 is formed.

Since the first wires 91 disposed on the upper surface of the first substrate 40 are a pattern by patterning the copper plating layers 99 and the copper wire layer 41, the copper plating layers 99 are present on the patterned copper wire layers 41. The second wires 92 have the copper plating layers 99 and the copper wire layers 41. Since the third wires 93 disposed on the upper surface of the second substrate 80 are formed by patterning the copper plating layers 99 and the copper wire layers 51, the copper plating layers 99 are disposed on the patterned copper wire layers 51. The fourth wires 94 include patterned copper plating layers 99, and connect the first wires 91 with the third wires 93. The first substrate 40 and the second substrate 80 are electrically connected by disposing the copper plating layers 99 so as to dispose across the boundary between the first substrate 40 and the second substrate 80.

Then, in the 11th step shown in Fig. 9A, a heat conductive layer adhesive sheet 96 and the heat conductive layer 97 are prepared. In the twelfth step shown in Fig. 9B, the heat conductive layer 97 is adhered on the rear surface of the synthetic substrate 90 via the heat conductive layer adhesive sheet 96, by thermal pressing. The manufacturing of the mounting substrate 100, i.e., an inlay substrate is completed by the processes from the first step to the twelfth step.

Then, in the thirteenth step shown in Fig. 9C, the plurality of light emitting elements 10 are mounted on the surface of the first substrate 40, and the control circuits 20 are mounted on the surface of the second substrate 80. For example, the plurality of light emitting elements 10 are flip-chip mounted on the surface of the second substrate 80 by solder connection. The plurality of light emitting elements 10 may be connected by other metallic connections such as CuSn connection and AuSn connection. Then, in the fourteenth step shown in Fig. 9D, the heat dissipation member 110 is mounted on the rear surface of the mounting substrate 100.

The heat dissipation member 110 is referred to as a heat sink, and is made of a metal material such as aluminum to dissipate heat conducted from the light emitting elements 10 via the first substrate 40, the heat conductive layer adhesive sheet 96 and the heat conductive layer 97. The heat dissipation member 110 may not be included in the light emitting device 1. When the heat dissipation member 110 is not included in the light emitting device 1, the fourteenth step is omitted.

### (Effect of a light-emission device according to the first embodiment)

The light emitting device 1 may mount the plurality of light emitting elements 10 on the first substrate 40 having a high thermal conductivity by forming through holes electrically connected with each of the plurality of light emitting elements 10 on the first substrate 40. The light emitting device 1 may have good irradiation characteristics of light in the projection surface, since the light emitting elements 10 are mounted in high density, and the dark portion on the projection surface 103 of the headlight mounting the light emitting device 1 where the light is not projected is reduced. Further, heat generated by the light emitting elements 10 mounted in high density on the first substrate 40 having a high thermal conductivity may be efficiently conducted to the heat conductive layer 97.

Further, in the light emitting device 1, since the fourth wires 94 are disposed across the surfaces of the first substrate 40 and the second substrate 80 by the copper plating layers 99, the connections between first wires 91 and the third wires 93 may be easier than connections by wire bonding. If the fourth wires 94 formed by the copper plating layers 99 are not disposed, the third wires 93 disposed on the first wires 91 are separated from the second substrate 80 disposed on the first substrate 40 by an adhesive band 82. Since the copper plating layers 99 are disposed so as to dispose across the adhesive band 82 in advance, the first wires 91, the third wires 93 and the fourth wires 94 are formed at the same time, by patterning the copper wire layers 41 and 51 and the copper plating layers 99. The fourth wires 94 formed by the copper plating layers 99 electrically connects the third wires 93 disposed on the second substrate 80 with the first wires 91 disposed on the first substrate 40.

Further, in the light emitting device 1, since the heat conductive layer 97 is disposed so as to cover all of the rear surface of the first substrate 40 and second substrate 80, the first substrate 40 and second substrate 80 are stably supported.

Further, in the light emitting device 1, the heat dissipation member 110 is disposed so as to contact with the heat conductive layer 97, the heat dissipation characteristics is further improved.

Further, in the light emitting device 1, the heat conductive layer 97 is made of the same material as the first substrate 40, and therefore the linear expansion coefficient of the thermal conductive layer 97 is the same as that of the first substrate 40, the heat dissipation characteristics are deteriorated by breaking up adhesion between the thermal conductive layer 97 and the first substrate 40.

### (Modification of the light emitting device according to the first embodiment)

In the light emitting device 1, one of the first wires 91 on the surface of the first substrate 40 which is connected via a through hole 95 to the light emitting element 10 is disposed between lines (hereinafter referred to as light emitting element line) formed by a plurality of light emitting elements in which the connected light emitting element 10 are included and adjacent light emitting element line. Thus, one first wires 91 connected with the light emitting element 10 and another first wire 91 connected with the third wire 93 are close to each other. However, in the light emitting device according to the first embodiment, the first wires 91 on the surface of the first substrate which is connected via a through hole to the light emitting element 10 may be spaced apart from the connected light emitting element 10. The first wires connected with the fourth wires may be disposed at a location far from the connected light emitting elements, by lengthening the second wires disposed on the rear surface of the first substrate.

Further, although the substrate adhesive sheet 60 in the light emitting device 1 is formed by thermally pressing sheets semi-cured by impregnating glass fibers with an adhesive, in the light emitting device according to the first embodiment, the first resin substrate 50 and the second resin substrate 70 may be adhered by an adhesive.

Further, although the thickness of the copper plating layers 99 in the light emitting device 1 is 50µm, in the light emitting device according to the first embodiment, the thickness of the copper plating layer may be 20µm or less. Since the wire pitch may be narrower as the height of the wire is lower, the wire pitch of the first wires 91 may be narrower, when the thickness of the copper plating layers is 20µm or less. Further, in the light emitting device according to the first embodiment, the wire pitch in the region on which the light emitting elements 10 are disposed may be narrower than the wire pitch in the other regions, by etching the copper plating layer, so that the thickness of the copper plating layer in the region on which the light emitting elements 10 are disposed is narrower than that of the other regions.

Further, in the light emitting device 1, the through holes formed in the first substrate 40 are formed by through-hole processing by a laser. However, in the light emitting device according to the first embodiment, the through hole may be forming on a ceramic before firing, i.e., a green sheet by using a mold or laser.

Further, in the light emitting device 1, the second substrate 80 is formed by three members of the first resin substrate 50, the substrate adhesive sheet 60 and the second resin substrate 70, in the light emitting device according to the first embodiment, the second substrate may be formed by a single member.

Further, although the substrate adhesive sheet 60 in the light emitting device 1 is formed by thermally pressing a sheet semi-cured by impregnating glass fibers with an adhesive, in the light emitting device according to the first embodiment, the substrate adhesive sheet 60 may be formed by thermally pressing a semi-cured adhesive sheet without glass fiber.

Further, although no wires are disposed on the second resin substrate 70 in the light emitting device 1, in the light emitting device according to the first embodiment, wires may be disposed on the rear surface of the second resin substrate, and wires may be disposed on both the front and rear surfaces of the second resin substrate. When wires are disposed on both the front and rear surfaces of the second resin substrate, the front and rear surfaces of the second resin substrate are connected by through holes. In that case, a more complicated circuit network may be formed.

### (Second Embodiment)

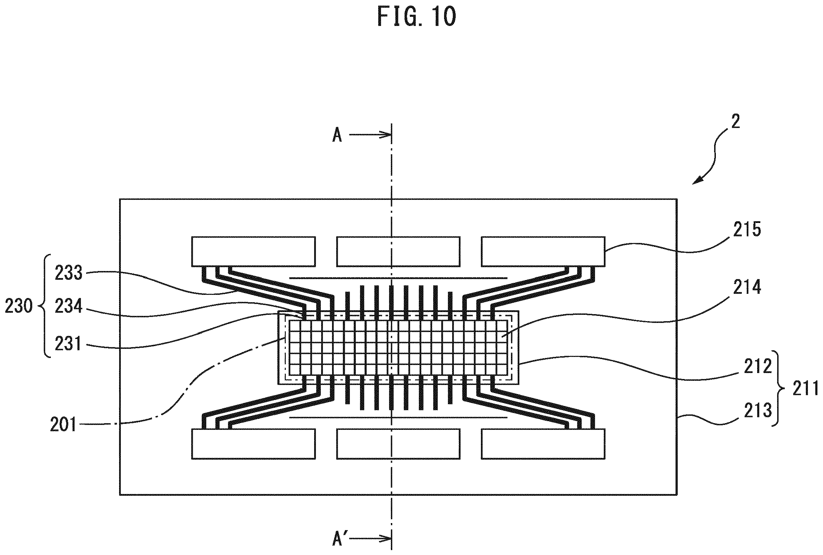

Fig. 10 is a planar view of the light emitting device 2 of a second embodiment. In Fig. 10 shows an outline of the main components and wires disposed on an inlay substrate 211 included in the light emitting device 2.

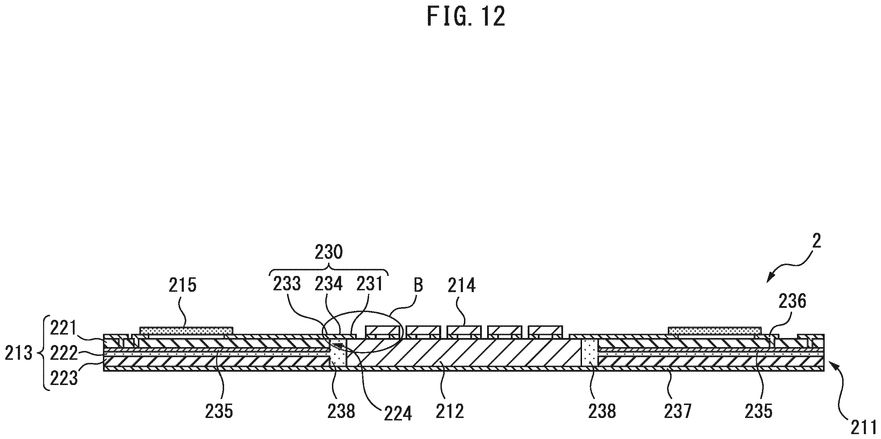

As shown in Fig. 10, the inlay substrate 211 has a silicon substrate 212 (first substrate) which is a heat dissipation substrate and a resin substrate 213 (second substrate), and the resin substrate 213 surrounds the outer periphery of the silicon substrate 212. LEDs 214 mounted on the silicon-substrate 212 are disposed in five rows and 20 columns in a matrix. Driver ICs 215 are mounted on a peripheral portion of the resin-substrate 213. Wires 230 laid to the upper surface of the silicon substrate 212 from terminals of the driver ICs 215 which are parts of the control circuits include first wires 231, third wires 233 and fourth wires 234. The first wires 231 are formed on the upper surface of the silicon substrate 212, the third wires 233 are formed on the upper surface of the resin substrate 213, and the fourth wires 234 connect the first wires 231 with the third wires 233 at the boundary 238 between the silicon substrate 212 and the resin substrate 213 (refer to Fig. 12).

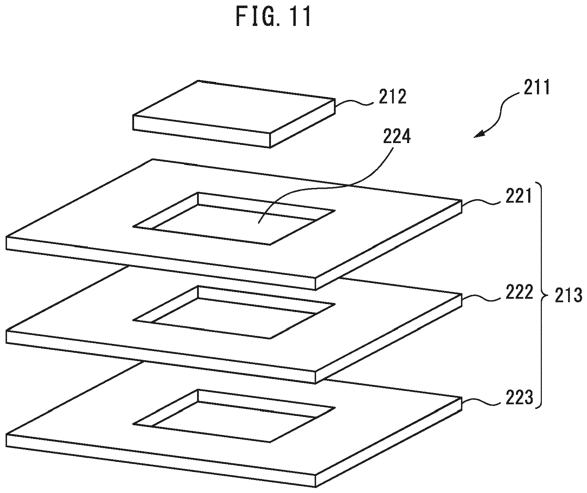

Fig. 11 is an exploded perspective view of the inlay substrate 211 included in the light emitting device 2. As explained above, the inlay substrate 211 has a silicon substrate 212 and the resin substrate 213, and the silicon substrate 212 is fitted into an opening 224 of the resin substrate 213. The resin substrate 213 has a first base material 221, a prepreg 222, and a second base material 223, and the prepreg 222 and the first base material 221 are laminated on the second base material 223. Further, common openings 224 are formed on the first base material 221, the second base material 223 and the prepreg 222.

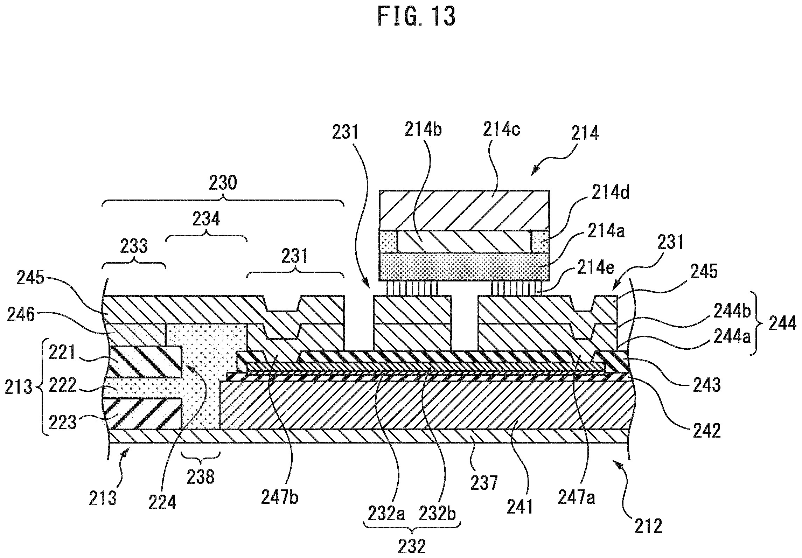

Fig. 12 is a cross-sectional view of the light emitting device 2 along the line AA' of Fig. 10. As shown in Fig. 12, the light emitting device 2 mounts the plurality of LEDs 214 on the inlay substrate 211. The silicon substrate 212 included in the inlay substrate 211 is a heat dissipation substrate, the first wires 231 are formed on the upper surface of the silicon substrate 212, and the LEDs 214 are mounted on the first wires 231. electrodes 214e (see Fig. 13) of LEDs 214 are connected with the first wires 231 by mounting the LEDs 214 on the first wires 231. The resin substrate 213 included in the inlay substrate 211 is disposed so as to surround the silicon substrate 212 includes the first substrate 221, the prepreg 222 and the second substrate 223. The first substrate 221 is a so-called both-surface printed circuit board, and has third wires 233 disposed on the upper surface, fifth wires 235 disposed on the lower surface, and through holes 236 for connecting the third wires 233 and the fifth wires 235. The driver ICs 215 are mounted on the resin substrate 213, and the terminals of the driver IC215 are connected with the third wires 233. The prepreg 222 is disposed between the first substrate 221 and the second substrate 223, and among the boundaries 238 of the silicon substrate 212 and the resin substrate 213. Copper patterns 237 are disposed over all of the lower surface of the inlay substrate 211.

Fig. 13 is a main cross-sectional view of the light emitting device 2 with respect to the region surrounded by the ellipse B shown in Fig. 12. An LED 214 in Fig. 13 disposed on the outer side of the matrix array (on the left side of the figure) and electrode 214e on the inner side of the matrix array (on the right side of the figure) are connected with wire 230 laid from one terminal of the driver IC 215 (refer to Fig. 10) to the upper surface of the silicon substrate 212.

As shown in Fig. 13, a silicon substrate 241, an insulating layer 242 of the lower layer, an insulating layer 243 of the upper layer, the first wire 231 and the second wire 232 are included the silicon substrate 212, and the insulating layer 242, the second wire 232, the insulating layer 243, the first wire 231 are laminated on the silicon substrate 241. Through holes 247a and 247b are formed in the insulating layer 243 so as to penetrate the inside of the insulating layer 243 in the thickness direction, in order to connect the first wires 231 with the second wires 232.

The first wires 231 to the fourth wires 234 and the through holes 247 electrically connect the light emitting elements 214 with the driver ICs 215. Apart of the first wires 231 connected with light emitting element 214 is electrically connected with the second wire 232 via the plurality of through holes 247 (through hole 247a) disposed on the array region 201 on which the plurality of light emitting elements 214 are mounted, and the second wire 232 is electrically connected with the first wire 231 via the plurality of through holes 247 (through hole 247b) disposed outside of the array region 201.

The silicon substrate 241 was cut from the silicon wafer, which is widely used in the so-called semiconductor industry, the thickness of the silicon substrate 241 is 0.725mm. The insulating layer 242 is formed by a SiO₂ film. The second wire 232 has a base layer 232a made of Ti, and a copper layer 232b. The insulating layer 243 (also referred to as interlayer insulating film) is a resin film made of a resin such as polyimide.

The first wires 231 are laminates including a copper layer 244 which is originally formed on the silicon substrate 12, and a copper layers 245 formed after fitting the silicon substrate 212 to the resin substrate 213, in order to connect the first wires 231 and the third wires 233. The copper layer 244 has a copper layer 244a formed by sputtering as a common electrode, and a thick copper layer 244b (about 15µm) formed by electrolytic plating. The thickness of the copper layer 245 is about 15µm. In the silicon substrate 241, the surface of the insulating layer 243 on which the first wires 241 are disposed is the uppermost wire layer, and the surface of the silicon substrate 241 on which the second wires 242 are disposed is a wire layer different from the wire layer on which the first wire 241 is disposed.

As explained above, the resin substrate 213 has the first base material 221, the prepreg 222, the second base material 223, and the third wire 233 disposed on the upper surface, and the prepreg 222, and the first base material 221 are laminated on the second base material 223. The third wires 233 are laminates including a copper layer 246 which is originally formed on the resin substrate 213, and a copper layer 245 formed after the silicon substrate 212 is fitted into the resin substrate 213, in order to connect with the copper layer 244a which is a material of the first wire 231. The first base material 221 and the second base material 223 are based on a resin plate in which an epoxy resin is impregnated into a cloth of glass fibers and thermally cured. The prepreg 222 is a semi-cured resin, and is cured by a compression heating treatment of the resin substrate 213 when the silicon substrate 212 is fitted into the resin substrate 213.

The LED 214 has a submount substrate 214a made of ceramics, an LED die 214b mounted on the submount substrate 214a, a fluorescent resin 214c covering the LED die 214b, a reflective resin 214d surrounding the LED die 214b, and protruding electrodes 214e formed on the lower surface of the submount substrate 214a. The LED 214 is a so-called CSP (Chip Size Package), the planar shape of the LED 214 is approximately equal to the planar outer shape of the LED die 214b. The planar size of the LED die 214b is about 0.4mm×0.4mm, and the thickness of the reflective resin 214d having the reflection and light shielding function and covering the side surface of the LED die 214b so as to surround the side surface thereof is about 0.1mm, and therefore the planar size of the LED 214 is about 0.6mm×0.6mm.

The electrode 214e on the right side in the figure formed on the lower part portion of LED 214 is connected with a terminal of the driver IC 215 (see Figs. 10 and 12) via the first wire 231, the through-hole 247a, the second wire 232, the other through-hole 247b, the other first wire 231, the fourth wire 234, and the third wire 233. The other first wire 231, the fourth wire 234 and the third wire 233 are included in the wire 230. The electrodes 214e on the left side in the figure, which are formed on the lower part portion of LED 214, are directly connected with other wires 230 (not shown).

A method for manufacturing a light emitting device 2 will be explained with reference to Fig. 13. First, the resin substrate 213 is prepared, the second wire 232 and the through holes 247a and 247b are formed on the resin substrate 213, the silicon substrate 212 whose entire upper surface is covered by the copper layer 244, the fifth wires 235 and the through holes 236 are formed on the resin substrate 213, and all of upper surface of the resin substrate 213 is covered by the copper layer 246. Then, the silicon substrate 212 is fitted into the resin substrate 213. When the silicon substrate 212 is fitted into the resin substrate 213, the resin substrate 213 is compressed and heated, the prepreg 222 exudes the boundary 238 of the silicon substrate 212 and the resin substrate 213, and the boundary 238 is filled by the prepreg 222. Prepreg 222 is cured by heating to fix the silicon substrate 212 to the resin substrate 213. Then, the upper surfaces of the copper layers 244 and 246 are polished together with the prepreg 222, and the upper surface of the prepreg 222 forms the same surface as that of the copper layers 244 and 246. Then, the copper layer 245 is formed on all of the upper surfaces of the prepreg 222 and the copper layers 244 and 246. Then, the copper layers 244 to 246 are patterned by photolithography to form the first wires 231, the third wires 233, and the fourth wires 234. Finally, the first wires 231, the third wires 233, the fourth wires 234 are gold-plated, and the LEDs 214 and the drivers ICs 215 are mounted via solder.

As explained above, in the light emitting device 2, the silicon substrate 212 is adopted as a heat dissipation substrate included in the inlay substrate 211, a large number of the LEDs 214 are mounted on the upper surface of the silicon substrate 212. The silicon substrate 212 has a large thermal conductivity, and may adopt fine processing and multilayer wire configuration. Therefore, in the inlay substrate 211 in which the silicon substrate 212 is fitted into the opening 224 of the resin substrate 213, even if a large number of the LEDs 214 are mounted in high density on the upper surface of the silicon substrate 212, the ends of the wires connecting to the electrodes 214e of the respective LED 214 may be disposed around the silicon substrate 212 by adopting the multilayer wire configuration for the silicon substrate 212. Thus, the light emitting device 2 has good heat dissipation characteristics, and reliably connects among elements or electrodes disposed or formed on the resin substrate 213, and the LEDs 214 mounted on the silicon substrate 212.

In the light emitting device 2, the patterns 237 formed by copper are disposed over all of the rear surface of the inlay substrate 211. Although the patterns 237 are not essential components, in the light emitting device 2, the patterns 237 may protect the prepreg 222, may improve the flatness of the lower surface of the inlay substrate 211, and may improve the heat dissipation characteristics to external heat sinks. In the light emitting device 2, the first wires 231 and the third wires 233 are connected via a fourth wires 234. Although the first wires 231 and the third wires 233 may be connected via other connecting means such as bonding wires, when the first wires 231 and the third wires 233 are connected via the fourth wires 234, reliability may be improved, and manufacturing cost may be reduced by simplifying manufacturing processes. If the mounting pitch of the LEDs 214 is 0.7mm, and the LEDs 214 are disposed in 5 rows × 20 columns, the pitch of the wires 230 on the peripheral portion of the silicon substrate 212 is about 0.14mm. Since the driver ICs 215 turn off the individual LEDs 214 by shorting the cathode (one electrode 214e) and the anode (the other electrode 214e) of the LED 214, two wires 230 are required per each LED 214. If 100 LEDs 214 are disposed, 200 wires 230 are disposed in total. Since a large number of wires 230 are disposed in a narrow pitch, when the wires 230 are formed by photolithography, the wires 230 are formed by aligning every inlay substrate 211 by direct laser figure.

### (Third Embodiment)

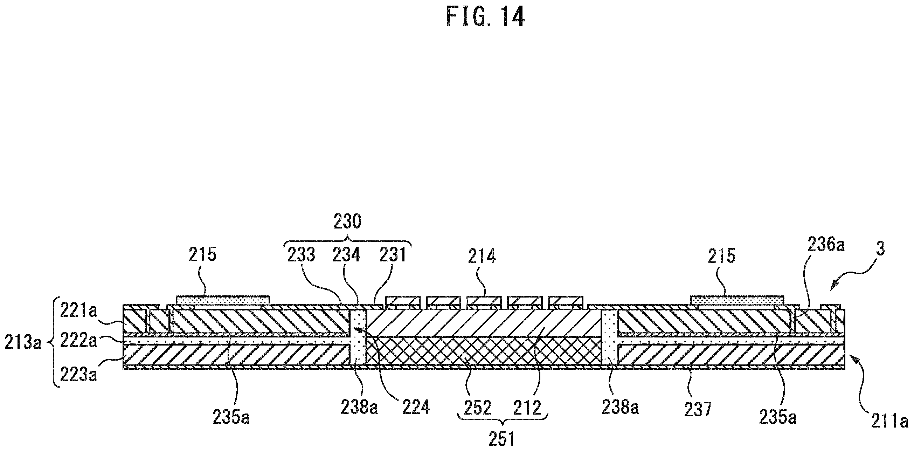

The thickness of the inlay substrate 211 included in the light emitting device 2 according to the second embodiment is about 0.7mm. Thus, the inlay substrate 211 is easily bent, in particular, the silicon substrate 212 is easily cracked. Fig. 14 shows a light emitting device 3 of a third embodiment, which hardly cracks the silicon substrate 212. Since a planar view, an exploded perspective view, a cross-sectional view of the silicon substrate 212 in the light emitting device 3 are similar to those of the silicon substrate 212 in the light emitting device 2, detailed explanations of the planar view, the exploded perspective view, the detailed description according to a cross-sectional view of the silicon substrate 212 of the light emitting device 3 are omitted, appropriately reference to Figs. 10 to 13 upon description of Fig. 14. The inlay substrate 211, the silicon substrate 212, and the resin substrate 213 shown in Fig. 10 are read as the inlay substrate 211a, the heat dissipation substrate 251, and the resin substrate 213a, respectively, in the descriptions of the light emitting device 3.

Fig. 14 is a cross-sectional view of the light emitting device 3 along the line AA' in Fig.10. The light emitting device 3 in Fig. 14 differs from the light emitting device 2 in Fig. 12 only in that the heat dissipation substrate 251 in Fig. 14 is a laminate of an aluminum nitride substrate 252 and a silicon substrate 212, and the inlay substrate 211a is thick. The inlay substrate 211a has a heat dissipation substrate 251 and a resin substrate 213a, and the heat dissipation substrate 251 is fitted into the opening 224 of the resin substrate 213a (shown in Fig. 11). The heat dissipation substrate 251 has an aluminum nitride substrate 252 and the silicon substrate 212, and the silicon substrate 212 is laminated on the aluminum nitride substrate 252. The aluminum nitride substrate 252 and the silicon substrate 212 are connected by a high thermal conductivity adhesive. A high-flatness gold layer is formed on the upper surface of the aluminum nitride substrate 252 by plating or polishing, a high-flatness gold layer is formed on the lower surface of the silicon substrate 212 by vapor deposition after polishing, and the aluminum nitride substrate 252 and the silicon substrate 212 may be metal bonded at an ordinary temperature. The thermal conductivity of the metal bond is higher than that of the adhesive material, and therefore the inlay substrate has better heat dissipation characteristics.

The wires 230 laid from the terminals of the driver ICs 215 to the upper surface of the silicon substrate 212 (refer to Fig. 10) include first wires 231, third wires 233 and fourth wires 234. The first wires 231 are formed on the upper surface of the silicon substrate 212, the third wires 233 are formed on the upper surface of the resin substrate 213a, and the fourth wires 234 are connecting the first wires 231 and the third wires 233 across the boundary 238a between the silicon substrate 212 and the resin substrate 213a.

The LEDs 214 are mounted on the top surface of the silicon substrate 212. When the LEDs 214 are mounted on the upper surface of the silicon substrate 212, the electrodes 214e formed on the lower portions of LEDs 214 are connected with the first wires 231. One of the electrodes 214e is connected with a terminal of the driver IC 215 via the first wire 231, the through hole 247a, the second wire 232, through hole 247b, the first wire 231, the fourth wire 234, and the third wire 233 (refer to Fig. 13).

The resin substrate 213a is a laminated substrate in which a prepreg 222a and a first base material 221a are laminated on a second base material 223a. The first base material 221a is a so-called double-sided printed circuit board, and includes a third wires 233 on the upper surface and a fifth wires 235a on the lower surface. Apart of the third wires 233 is connected with the fifth wires 235a via a through hole 236a. The boundary 238a between the heat dissipation substrate 251 and the resin substrate 213a is filled with the prepreg 222a. The copper pattern 237 is disposed over all of the lower surface of the inlay substrate 211a.

As explained above, compared with the light emitting device 2, the rear surface of the silicon substrate 212 in the light emitting device 3 is reinforced with high aluminum nitride substrate 252 having a thermal conductivity, thereby increasing the thickness of the resin substrate 213a. Since the thickness of the aluminum nitride substrate 252 is about 0.4mm, the thickness of the inlay substrate 211a is about 1.1mm.
The light emitting device 3 has good heat dissipation characteristics, and elements and electrodes disposed or formed on the resin substrate 213a may be reliably connected with the LEDs 214 mounted on the silicon substrate 212, and the silicon substrate 212 is hardly cracked as compared with the light emitting device 2.

The light emitting devices 2 and 3 have a copper layer 245 on all of the first wire 231 in the silicon substrate 212. However, if the copper layers 245 are not disposed on the region for mounting the LEDs 214 on the silicon substrate 212 in a matrix, the pitch of the first wires 231 may be smaller. Since the lengths of the line and space of the wires are two or more times longer than the thickness of the copper layer, it is effective that the copper layers 245 in the mounting region of the LEDs 214 are removed and the thickness of the copper layer (copper layer 244 only) is reduced.

The copper layers 245 are formed on portions other than the region on which the protective layers are disposed, by forming a protective layer (dry film) in the region on which the LEDs 214 are disposed in a matrix, immediately before forming the copper layer 245 on all of the surface of the inlay substrate 211, and electroless plating, or electric field plating to form a copper layer 245. Further, protective layers may be formed on portions other than the region on which the protective layers are formed, after forming the copper layer 245 on all of the surface of the inlay substrate 211, and the copper layer 245 may be etched or mechanical polished.

### (Fourth Embodiment)

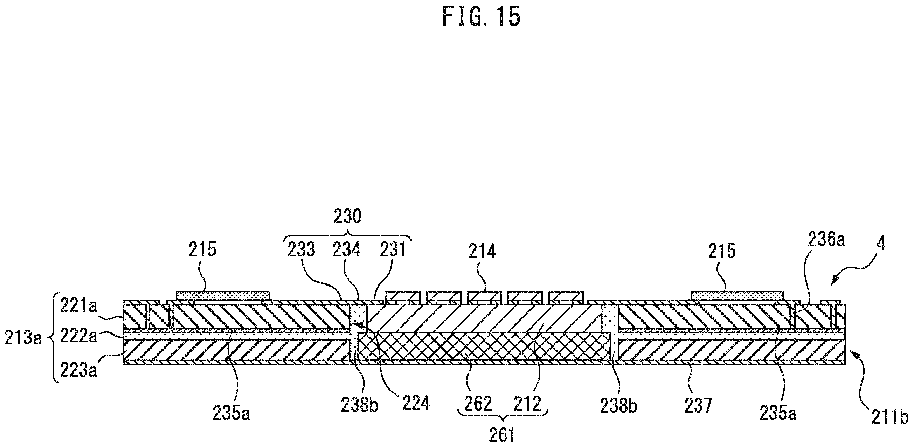

In the heat dissipation substrate 251 included in the light emitting device 3 of the third embodiment, the planar size of the aluminum nitride substrate 252 (ceramic substrate) is equal to that of the silicon substrate 212. However, in the light emitting device according to the embodiment, the planar size of the silicon substrate may be different from that of the aluminum nitride substrate. A light emitting device 4 of a fourth embodiment is indicated in Fig. 15 in which the planar size of the aluminum nitride substrate 262 (ceramic substrate) is larger than that of the silicon substrate 212, i.e., the area of the aluminum nitride substrate 252 in planar view is larger than that of the silicon substrate 212. Since a planar view, an exploded perspective view, a cross-sectional view of the silicon substrate 12 in the light emitting device 4 is substantially the same as those of the light emitting devices 2 and 3, detailed explanations of the planar view, the exploded perspective view, the cross-sectional view of the silicon substrate 212 in the light emitting device 4 are omitted, and Figs. 10, 11 and 13 are referred to as appropriate upon description of Fig. 15. The inlay substrate 211, the silicon substrate 212 and the resin substrate 213 shown in Fig. 10 are read as respectively an inlay substrate 211b, a heat dissipation substrate 261 and the resin substrate 213a on the description of the light emitting device 4,.

Fig. 15 is a cross-sectional view of a light emitting device 4 along the line AA' in Fig. 10. The light emitting device 4 in Fig. 15 is different from the light emitting device 3 in Fig. 14 in that the planar size of the aluminum nitride substrate (ceramic substrate) 262 in the heat dissipation substrate 261 in Fig. 15 is larger than that of the silicon substrate 212. In the light emitting device 4, the heat dissipation substrate 261 included in the inlay substrate 211b shown in Fig. 15 is fitted into the opening 224 of the resin substrate 213a included in the light emitting device 3 shown in Fig. 14. Thus, the lower portion of the boundary 238b between the resin substrate 213a and the heat dissipation substrate 261 is narrower than that of the boundary 238 of the light emitting device 3 (refer to in Fig. 14).

In the light emitting device 4, the adhesive protruding from the bottom surface of the silicon substrate 212 on the upper surface of the aluminum nitride substrate 262 creeps up the side lower end portion of the silicon substrate 212. The adhesive strengths of the silicon substrate 212 and the aluminum nitride substrate 262 are increased by anchoring effect of the adhesive material at the corners between the lower side end of the silicon substrate 212 and the upper surface of the aluminum nitride substrate 262. Further, even if the alignment of the silicon substrate 212 is shifted, since the silicon substrate 212 does not protrude from the aluminum nitride substrate 262, the silicon substrate 212 cracks and cracks are hardly generated.

As explained above, since the planar size of the aluminum nitride substrate 262 in the heat dissipation substrate 261 is larger than that of the silicon substrate 212, even if a large number of LED 214 are mounted in high density on the upper surface of the heat dissipation substrate 261 fitted in the opening 224 of the resin substrate 213a, the light emitting device 4 has good heat dissipation characteristics, the elements and electrodes disposed or formed on the resin substrate 213a may be reliably connected with the LEDs 214 mounted on the silicon substrate 212, the adhesive strengths of the silicon substrate 212 and the aluminum nitride substrate 262 may be increased, and it is difficult to generate cracks and cracks in the silicon substrate 212.

### (Fifth Embodiment)

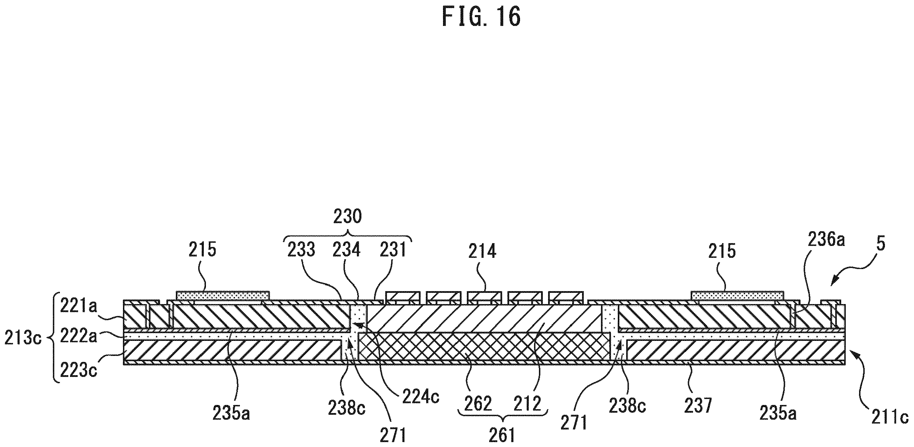

In the resin substrate 213a included in the light emitting devices 3 and 4 of the third and fourth embodiments, the openings of the first base material 221a and the second base material 223a (hereinafter, for convenience, the openings of the first base material 221a and the second base material 223a are distinguished from the openings 224 of the resin substrate 213a) have the same shape and axis. When the resin substrate 213a is formed by laminating the first base material 221a and the second base material 223a, the respective openings overlap with each other, and the sides thereof coincide with each other. However, in the light emitting device according to the embodiment, a step may be formed in the opening of the resin substrate. The light emitting device 5 having the step 271 in the opening portion 224c of the resin substrate 213c is shown in Fig. 16 of the fifth embodiment, since the opening of the second base material 223c is larger than that of the first base material 221a.

The heat dissipation substrate 261 is the same as that of the light emitting device 4 (refer to Fig. 15). In the light emitting device 5, since a planar view, an exploded perspective view, and a cross-sectional view of the silicon substrate 212 is substantially the same as those of the light emitting devices 2, 3 and 4, detailed explanations according to the planar view, the exploded perspective view, and the cross-sectional view of the silicon substrate 212 of the LED light emitting device 5 are omitted, Figs. 10, 11 and 13 are referred to as appropriate upon description of Fig. 16. The inlay substrate 211, the silicon substrate 212, and the resin substrate 213 shown in Fig. 10 are read as an inlay substrate 211c, a heat dissipation substrate 261, and a resin substrate 213c, respectively, in the explanations of the light emitting device 5.

Fig. 16 is a cross-sectional view of a light emitting device 5 along the line AA' in Fig.10. The light emitting device 5 in Fig. 16 differs from the light emitting device 4 of Fig. 15 in that he opening of the second base material 223c in Fig. 16 is larger than the opening of the first base material 221a(refer to Fig. 15). The resin substrate 211c has a step 271 on the peripheral portion of an opening 224c. Since the resin substrate 211c has the step 271 on the peripheral portion of the opening 224c in which the rear surface side of the resin substrate 213c is recessed from the front surface side of the resin substrate 213c, the boundary 238c between the resin substrate 213c and the heat dissipation substrate 261 has a crank shape as a whole, whereas the boundary 238b (refer to Fig. 15) of the light emitting device 4 has a straight side wall (side surface) of the opening 224.

In the light emitting device 5, since the step 271 is in the opening portion 224c, the area of the peripheral portion of the opening portion 224c is larger than that of the opening portion 224 of the resin substrate 213a included in the light emitting device 4. The adhesive strength between the resin substrate 213c and the heat dissipation substrate 261 increases. Further, when the planar sizes of the opening 224c and the aluminum nitride substrate 262 are adjusted so that the lower surface of the first base material 221a and the upper surface of the aluminum nitride substrate 262 overlap, the wire length of the fourth wires 234 connecting the third wires 233 formed on the upper surface of the first base material 221a with the first wires 231 formed on the upper surface of the silicon substrate 12 may be shortened, and peeling or disconnection of the fourth wires 234 hardly occur.

### (Sixth Embodiment)

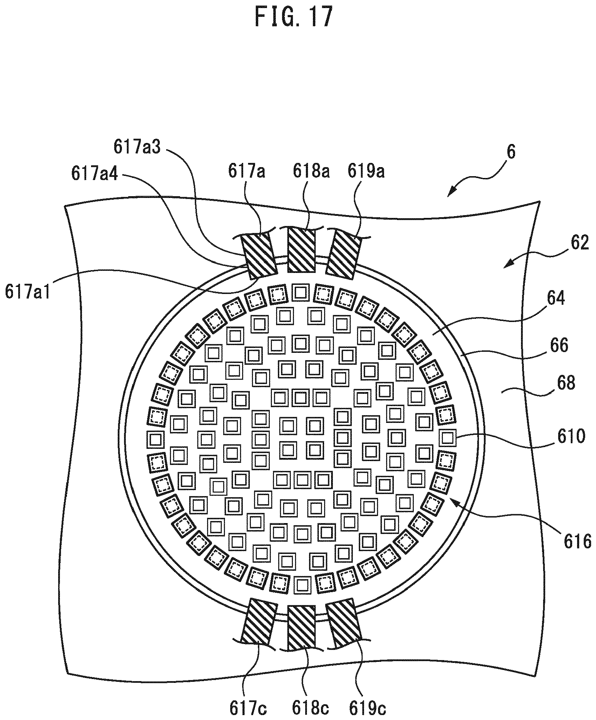

The inlay substrates 100, 211, 211a to 211c and the light emitting devices 1 to 5 of the first to fifth embodiments explained above relate to a headlight. However, applications of an inlay substrate and a light emitting device using the inlay substrate according to the present invention are not limited to a headlight. An inlay substrate and a light emitting device using the inlay substrate according to the present invention is useful for applications relating to a light emitting device miniaturizing a light source in order to miniaturize a lens and a reflecting mirror, or adding many functions to a light source, thereby having complicated wire connections. Accordingly, a light emitting device 6 of a sixth embodiment performing beam tuning for switching illumination ranges will be explained with reference to Figs. 17 to 19.

Fig. 17 is a planar view of a light emitting device 6 showing the light emitting portion 616 and its peripheral portion included in the light emitting device 6. An inlay substrate 62 included in the light emitting device 6 has a first substrate 64 and a second substrate 68. The first substrate 64 has a high heat dissipation characteristics, has circular shape in a planar view, and is formed by laminating a silicon substrate on the aluminum nitride substrate as in the third embodiment, and the multilayer wire configuration is formed on the upper surface. The second substrate 68 is made of a resin similarly to the second substrate 80 shown in the first embodiment, and has a circular opening, and the first substrate 64 is fitted into the opening.

Light emitting elements 610 are disposed on the first substrate 64 so as to be disposed in a six-fold annulus. 40 light emitting elements 610 disposed on the outermost peripheral portion are disposed so as to change the direction of the sides along the annulus, in order to increase the arrangement density (linear density along the annulus). The sides of the light emitting elements 610 included in the remaining five circulars are facing one direction (horizontal or vertical direction). The second, third, fourth, fifth and sixth circulars from the outermost circular include 28, 24, 16, 12 and 4 light emitting elements 610, respectively.

In the inlay substrate 62, the electrodes 617a, 617c, 618a, 618c, 619a, 619c are formed across the boundary between the first substrate 64 and the second substrate 68(shown only in part, respectively). The electrode 617a is formed by the first wire 617a1 formed on the upper surface of the first substrate 64, the fourth wire 617a4 disposed across the prepreg 66 and the third wire 617a3 formed on the second substrate 68 (the electrodes 617c, 618a, 618c, 619a, and 619c are similar to the electrode 617a).

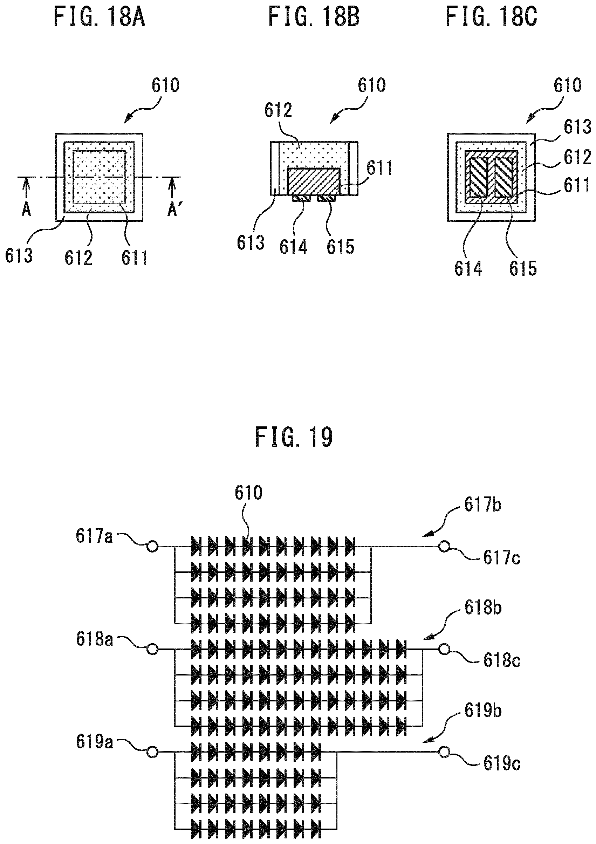

Figs. 18A to 18C are explanatory figures of a light emitting element 610 in the light emitting device 6, Fig. 18A is a planar view thereof, Fig. 18B is a cross-sectional view thereof, and Fig. 18C is a bottom view thereof. The light emitting element 610 is a CSP (chip size package) similarly to the light emitting element 10 shown in the first embodiment. As shown in Fig. 18A, when the light emitting element 610 is viewed from above, a white reflection frame 613 on the outermost peripheral portion, a sealing resin 612 in the inner region of the white reflection frame 613, and a LED die 611 via the sealing resin 612 are observed. As shown in Fig. 18B, in the cross section along the line AA' in Fig. 18A, the white reflection frame 613 standing upright at both left and right ends, the LED die 611 disposed in the center portion of the figure, the sealing resin 612 filled among the white reflection frame 613 so as to cover the LED die 611, and electrodes 614 and 615 formed on the lower surface of the LED die 611 are observed.

The reflection frame 613 is a silicon resin containing white reflection particles such as titanium oxide, the thickness of reflection frame 613 is 100µm, and a height of the reflection frame 613 is less than 1mm. The sealing resin 612 is a silicon resin containing phosphors, the thickness of the portion in contact with the side surface of the LED die 611 is about 100µm. The planar size of the LED die 611 is 0.6mm x 0.6mm, and the electrodes 614 and 615 on the underside are the anode and cathode. The planar size of the light emitting element 610 is 1.0mm×1.0mm.

Fig. 19 is a circuit figure of a circuit on the first substrate 64. In Fig. 19, a light emitting block 617b has 40 light emitting elements 610 forming an outermost ring on the light emitting portion 616, and four light emitting element lines in which 10 light emitting elements 610 are connected in series are connected in parallel between the terminal 617a and the terminal 617c. A light emitting block 618b has 52 light emitting elements 610 forming the second and third rings from the outermost circumference on the light emitting portion 616, and four light emitting element lines in which 13 light emitting elements 610 are connected in series are connected in parallel between the terminals 618a and 618c. A light emitting block 619b has 32 light emitting elements 610 constituting the fourth, fifth and sixth circular rings from the outermost circumference on the light emitting portion 616, and four light emitting element lines in which 8 light emitting elements 610 are connected in series are connected in parallel between the terminal 619a and the terminal 619c. In the light emitting device 6, the number of the light emitting elements in series is determined so that all of the light emitting blocks 617b, 618b and 619b may be driven at 40V or less.

The light emitting device 6 is used by disposing a lens directly above the light emitting portion 616. Further, in the light emitting device 6, when all of the light emitting elements 610 included in the light emitting portion 616 (in the light emitting blocks 617b, 618b and 619b) are turned on, the distribution of light emitted from the lens is the widest radiation angle, a wide range is illuminated. The light emitting elements 610 included in the outermost periphery on the light emitting portion 616 (light emitting block 617b) are turned off, whereas the other light emitting elements 610 (in the light emitting block 618b and 619b) are turned on, the distribution of the light rays emitted from the lens is narrowed, the range to be illuminated is narrowed. When the light emitting elements 610 (in the light emitting blocks 617b and 618b) included in the first to third annulus from the outermost periphery on the light emitting portion 616 are turned off whereas the remaining light emitting elements 610 (in the light emitting block 619b) are turned on, the distribution of the light rays emitted from the lens is the smallest radiation angle, and the narrowest range is illuminated.

As explained above, since the light emitting elements 610 are disposed on the first substrate 64 in high density, the beam tuning may be done with small optical elements (such as a lens) in the light emitting device 6. Similarly to other embodiments, when wire connections on the first substrate 64 are complicated, multilayer wire configuration may be used, and therefore the light emitting device 6 has high heat dissipation characteristics, and various functions may be added to the second substrate 68.

### (Seventh Embodiment)

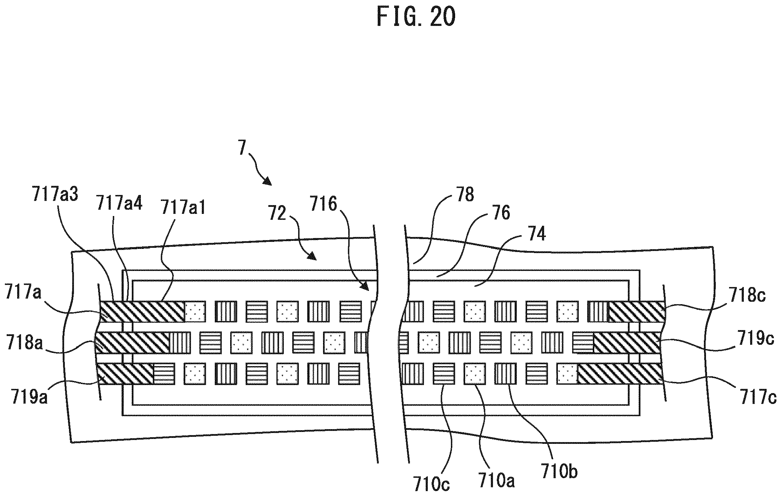

As explained above, the light emitting devices according to the present disclosure may be mounted on a headlight and lighting devices other than a headlight. For example, the light emitting device according to the present disclosure may be used as backlight of a large LED display, by downsizing the light emitting portion by using CSP, and using a small lens or reflecting mirror. In Fig. 20, a linear light source of a seventh embodiment will be explained that may be used for the backlight of the LED display (light emitting device 7).

Fig. 20 is a planar view of a light emitting device 7 showing a light emitting portion 716 included in the light emitting device 7 and the peripheral portion thereof. An inlay substrate 72 included in the light emitting device 7 has a first substrate 74 and a second substrate 78. The first substrate 74 has high heat dissipation characteristics, and has a rectangle shape in a planar view, and forming by laminating a silicon substrate on the aluminum nitride substrate similar to the third embodiment, and the multilayer wire configuration is formed on the upper surface. The second substrate 78 is made of a resin, similarly to the second substrate 80 shown in the first embodiment, and has a rectangular opening, into which the first substrate 74 is fitted.

Red light emitting elements 710a emitting red light, green light emitting elements 710b emitting green light, and blue light emitting elements 710c emitting blue light are alternately disposed on the first substrate 74 (delta arrangement).

The electrodes 717a, 717c, 718a, 718c, 719a and 719c are formed on the inlay substrate 72 so that the electrodes are disposed across the boundary between the first substrate 74 and the second substrate 78(shown only in part, respectively). The electrode 717a includes a first wire 717a1 formed on the upper surface of the first substrate 74, a fourth wire 717a4 disposed across the prepreg 76, and a third wire 717a3 formed on the second substrate 78 (the electrodes 717c, 718a, 718c, 719a, and 719c are similar to the electrode 717a).

The red light emitting elements 710a, the green light emitting elements 710b and the blue light emitting elements 710c may have LED dies emitting lights in red, green and blue, respectively. Each of the red light emitting elements 710a, the green light emitting elements 710b and the blue light emitting elements 710c may have the same configuration as that of the light emitting element 610 explained with reference to Figs. 18A to 18C. For example, the red light emitting element 710a has a blue LED die emitting blue light and a sealing resin containing red phosphors such as CaAlSiN₃ (calcium-aluminum-silicon trinitride) of Eu²⁺ (europium) solid solution which emits red lights converted from blue lights emitted from the blue LED die. For example, the green light emitting element 710b has a blue LED die emitting blue light, and a sealing resin containing green phosphors such as β-SiALON(Si_{6-z}Al_{z}O_{z}N_{8-z} : Eu) which emits green lights converted from blue lights emitted from the blue LED die. For example, the blue light emitting element 710b has a blue LED die emitting blue light, and a sealing resin containing no phosphors.

In the light emitting element 7, the red light emitting elements 710a are connected in series by connecting an electrode 717a as a + side (anode side) with an electrode 717c as a - side (cathode side). The green light emitting elements 710b and blue light emitting elements 710c are connected in series by connecting electrodes 718a and 719a as a + sides and electrodes 718c with 719c as a - sides, respectively. However, when the light emitting device 7 is viewed from above, wires (not shown) for connecting the red light emitting elements 710a , wires (not shown) for connecting the green light emitting elements 710b, wires (not shown) for connecting the blue light emitting elements 710c cross each other. Even if the wires cross each other in planar view, so as not to short between wires three-dimensionally, by applying a multilayer wire configuration to the wires on first substrate 74.

As explained above, in the light emitting device 7, the red light emitting elements 710a, the green light emitting elements 710b, and the blue light emitting elements 710c are disposed on the first substrate 74 in high density, and therefore a linear light source emitting various color lights may be formed. Similarly to other embodiments, even if the wire connections on the first substrate 74 are complicated, the light emitting device 7 may have high heat dissipation characteristics, various functions may be added to the second substrate 78, by using multilayer wire configuration. When the light emitting device 7 is disposed so as to face to a side surface of the flat light guide plate, the light emitting device 7 is a light source of the side light type backlight.

### (Eighth Embodiment)

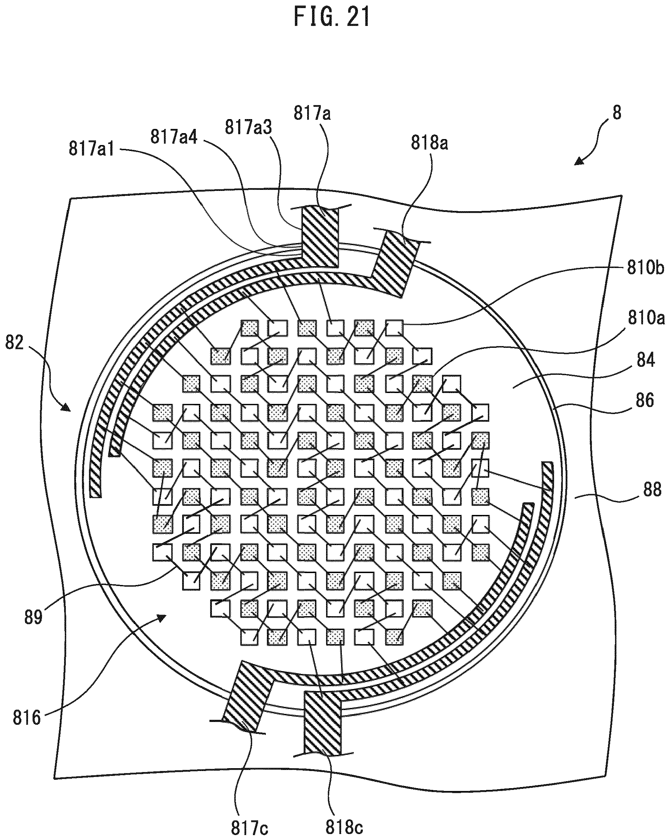

The light emitting device 7 of the seventh embodiment may emit various color lights by adjusting the emission intensity ratio among the red light emitting elements 710a, the green light emitting elements 710b and the blue light emitting elements 710. However, in practice, it may be sufficient for a lighting device to adjust only color temperature. A light emitting device 8 adjusting color temperature of a eighth embodiment of the present invention will be explained with reference to Fig. 21.

Fig. 21 is a planar view of the light emitting portion 816 and peripheral portion included in the light emitting device 8. In Fig. 21, squares with dots indicate cool light emitting elements 810a, and squares without dots indicate warm light emitting elements 810b. In Fig. 21, wires 89 between the cool light emitting elements 810a, between the warm light emitting elements 810b, between the cool light emitting elements 810a and the electrodes 817a and 817c, and between the warm light emitting elements 810b and the electrodes 818a and 818c are shown in a simplified manner by straight lines.

An inlay substrate 82 included in the light emitting device 8 have a first substrate 84 and a second substrate 88. The first substrate 84 has a high heat dissipation characteristics, has a circular shape in planar view, and is formed by laminating a silicon substrate on the aluminum nitride substrate similar to the third embodiment, a multilayer wire configuration is formed on the upper surface of the first substrate 84. The second substrate 88 is made of a resin similarly to the second substrate 80 shown in the first embodiment, and has a circular opening into which the first substrate 84 is fitted.

In Fig. 21, the cool light emitting elements 810a with dots are and the warm light emitting elements 810b without dots are alternately disposed on the first substrate 84. For example, the cool light emitting elements 710a emit light in a cool color having a color temperature of 6500K, and the warm light emitting elements 710b emit light in a warm color having a color temperature of 3500K.

The electrodes 817a, 817c, 818a and 818c are formed on the inlay substrate 82 so that the electrodes are disposed across the boundary between the first substrate 84 and the second substrate 88 (shown only partially, respectively). The electrode 817a includes a first wire 817a1 formed on the upper surface of the first substrate 84, a fourth wire 817a4 is disposed across the prepreg 86, and a third wire 817a3 formed on the second substrate 88 (the electrodes 817c, 818a, and 818c are similar to the electrode 817a).

Each of the cool light emitting element 810a and the warm light emitting element 810b may have the same configuration as the light emitting element 610 explained with reference to Figs. 18A to 18C. For example, each of the cool light emitting element 810a and the warm light emitting element 810b has a blue LED die emitting blue light and a sealing resin containing red phosphors that convert blue light emitted from a blue LED die into red light and emits the red light and green phosphors that convert blue light emitted from a blue LED die into green light and emits the green light. For example, the red phosphor is a CaAlSiN₃ with Eu²⁺ (europium) solid solution (Ca-Al-Silicon Tri-Nitride) and the green phosphor is β-SiALON(Si₆-_{z}Al_{z}O_{z}N₈-_{z}:Eu). The ratio of the red phosphor and the green phosphor in the sealing resins including the cool light emitting element 810a and the warm light emitting element 810b is adjusted so as to emit light having a desired temperature.

In the light emitting element 8, the cool light emitting element 810a are connected in 12-5 parallel, by connecting electrodes 817a as a + side (anode side) with electrodes 817c as a - side (cathode side) (hereinafter, five light emitting element lines in which 12 LED dies 810a are connected in series are connected in parallel). The warm color light emitting elements 810b are connected in 12 to 5 parallel, by connecting the electrodes 818c as a + side with the electrodes 818a as a - side. As shown in Fig. 21, when the cool light emitting elements 810a and the warm light emitting elements 810b are disposed on a substantially circular region in a checkered pattern, and are connected in 12 to 5 parallel, the wires 89 cross each other at a plurality of locations. Thus, a multilayer wire configuration included in the first substrate 84 is applied to wires 89, and even if the wires 89 (including the electrodes 818a and 818c) cross each other in planar view, the wires 89 are not short.

As explained above, the light emitting device 8 has the cool light emitting elements 810a and the warm light emitting elements 810b disposed on the first substrate 78 in high density, and a light source that emits light having various color temperatures may be formed. Even if wire connections are complicated, the light emitting device 8 may have good heat dissipation characteristics, and add various functions on the second substrate 88, by using multilayer wire configuration to wire connections on the first substrate 84.

Further, although the above explained embodiments are light emitting devices mounting light emitting elements such as LEDs on an inlay substrate, the inlay substrate according to the present invention may mount elements other than the light emitting elements that generate heat with operation.

Further, the light emitting device according to the embodiment may be the following aspects.
(1) Alight emitting device including:
   a plurality of light emitting elements;
   a first substrate mounting the plurality of light emitting elements in array on the front surface, and a second substrate into which the first substrate is inserted;
   first wires disposed on the front surface the first substrate;
   second wires disposed on a the rear surface of the first substrate, wherein
   the substrate has a plurality of vias are formed so as to penetrate the inside of the first substrate in the thickness direction,
   the second substrate has third wires disposed on the front surface,
   the plurality of wires are connected with the first wires,
   one first wires of the first wires connected with the plurality of light emitting elements is electrically connected with the second wire through one via of the plurality of vias disposed on the array region in which the plurality of light emitting elements are mounted, and the second wire is electrically connected with other first wire through another via of the plurality of vias disposed outside the array region,
   the first wires and the third wires are connected by fourth wires disposed across the surfaces of the first substrate and the second substrate, and
   the thermal conductivity of the first substrate is larger than that of the second substrate.
(2) The light emitting device according to (1), wherein
   a heat conductive layer disposed so as to face to the rear surfaces of the first and second substrates, and
   an insulating heat conductive layer disposed between the first and second substrates and the heat conductive layer, conducts heat conducted from the plurality of light emitting elements through the first substrate to the heat conductive layer, and insulating the second wires and the heat conductive layer disposed on the rear surface of the first substrate.

Furthermore, the light emitting device according to the embodiment may be the following aspects.
(1) A LED light emitting device including a plurality of LEDs mounted on the front surface of heat dissipation substrate inserted into a resin substrate, wherein
   the heat dissipation substrate includes a silicon substrate,
   the silicon substrate has first wires on the front surface, an insulating layer covering the first wires, and second wires formed on the insulating layer,
   the resin substrate has third wires on the front surface,
   fourth wires are disposed across the boundary between the silicon substrate and the resin substrate, and connecting the first wires with the third wires,
   an electrode of the LED is connected with one second wire of the second wires,
   the one second wire is connected with one first wire of the first wires via one through hole of the through holes,
   the one first wire is connected with other second wire of the second wires via other through hole,
   the other second wire is connected with one three wire of the three wires via one four wire of the four wires.
(2) The LED light emitting device according to (1), wherein
   the heat dissipation substrate includes ceramic substrate, and
   the silicon substrate is mounted on the ceramic substrate.
(3) The LED light emitting device according to (1) or (2), wherein
   the thickness of the second wires in an region on which the LEDs are mounted is thicker than that of the second wires in regions except for the region on which the LEDs are mounted.
(4) The LED light emitting device according to any of (1) to (3), wherein the area of the ceramic substrate in planar view is larger than that of the silicon substrate.
(5) The LED light emitting device according to any of (1) to (4), wherein the opening has a step on the peripheral portion.

## Claims

1. A light emitting device comprising:
a plurality of light emitting elements;
a first substrate having a plurality of wire layers and mounting the plurality of light emitting elements;
a second substrate forming an opening into which the first substrate is inserted, and having smaller thermal conductivity than that of the first substrate;
first wires disposed on the uppermost wire layer in the plurality of wire layers on the first substrate, and connected with the plurality of light emitting elements;
second wires disposed on a wire layer different from the wire layer on which the first wires are disposed, and connected with the first wires via any of a plurality of through holes formed between the wire layers on which the first and second wires are disposed;
third wires disposed on the second substrate; and
fourth wires disposed across the boundary between the first substrate and the second substrate, and connecting the first wires with the third wires.

2. The light emitting device according to claim 1, wherein
one of the first wires connected with the plurality of light emitting elements is electrically connected with the second wire via one of the plurality of through holes disposed on the array region on which the plurality of light emitting elements are mounted,
the second wire is electrically connected with other first wire via another through hole of the plurality of through holes disposed outside the array region, and
the first wire and the third wire are electrically connected via the fourth wire.

3. The light emitting device according to claim 1 or 2, wherein
the wire layer on which the first wires are disposed is the front surface of the first substrate,
the wire layer on which the second wires are disposed is the rear surface of the first substrate, and
the plurality of through holes are formed so as to penetrate the inside of the first substrate in the thickness direction.

4. The light emitting device according to any of claims 1 to 3, further comprising:
a heat conductive layer disposed so as to face to the rear surfaces of the first and second substrates; and
an insulating heat conductive layer disposed between the first and second substrates and the heat conductive layer, conducts heat conducted from the plurality of light emitting elements via the first substrate to the heat conductive layer, and insulating the heat conductive layer with the second wires disposed on the rear surface of the first and second substrates.

5. The light emitting device according to claim 1, wherein
the first substrate includes a silicon substrate, wherein an insulating layer is formed on the surface of the silicon substrate,
the wire layer on which the first wires are disposed is the surface of the insulating layer,
the wire layer on which the second wires are disposed is the surface of the silicon substrate covered by the insulating layer, and
the plurality of through holes are formed so as to penetrate the inside of the insulating layer in the thickness direction.

6. The light emitting device according to claim 5, wherein the thickness of the first wires disposed in an array region is thicker than that of the first wires disposed outside an array region.

7. The light emitting device according to claim 5 or 6, wherein the first substrate further includes a ceramic substrate mounting the silicon substrate.

8. The light emitting device according to claim 7, wherein the area of the ceramic substrate in planar view is larger than that of the silicon substrate.

9. The light emitting device according to claim 8, wherein a step is formed on the peripheral portion of the opening, so that the rear surface side of the second substrate is recessed from the front surface side of the second substrate.

10. An inlay substrate comprising:
a first substrate having a plurality of wire layers and capable of mounting a plurality of light emitting elements;
a second substrate forming an opening into which the first substrate is inserted, and having smaller thermal conductivity than that of the first substrate;
first wires disposed on the uppermost wire layer in the plurality of wire layers on the first substrate;
second wires disposed on a wire layer different from the wire layer on which the wires are disposed, and connected with the first wires via a plurality of through holes formed between the wire layers on which the first and second wires are disposed;
third wires disposed on the second substrate; and
fourth wires disposed across the boundary between the first substrate and the second substrate, and connecting the first wires with the third wires.
